# EUROPEAN PATENT SPECIFICATION

(11) **EP 2 644 284 B1**
(45) Date of publication and mention of the grant of the patent: **03.06.2015**
(21) Application number: 13161953.8
(22) Date of filing: 02.04.2013
(51) Int. Cl.: B05D 5/12, C07F 3/00, C07F 3/02, C07F 3/04, C23C 4/10, H01L 21/288, C23C 16/18, C09D 5/24, C23C 16/34, C23C 16/40, C23C 16/455, H01L 21/02

(54) **Group 2 imidazolate formulations for direct liquid injection**
Gruppe-2-Imidazolat-Formulierungen für direkte Flüssigkeitseinspritzung
Formulations d'imidazolate de groupe 2 pour l'injection directe de liquide

(30) Priority: 30.03.2012 US 201261618019 P; 22.03.2013 US 201313848808
(43) Date of publication of application: 02.10.2013
(73) Proprietor: Air Products and Chemicals, Inc., Allentown, PA 18195-1501 (US)
(72) Inventor: Norman, John, Anthony, Thomas, Encinitas, CA 92024 (US); Perez, Melanie, K., San Diego, CA 92128 (US)
(74) Representative: Beck Greener

(56) References cited:
- EP-A1- 2 256 121
- EP-A1- 2 371 821
- US-A1- 2011 212 629
- JOHN A. T. NORMAN ET AL: "New Volatile Strontium and Barium Imidazolate Complexes for the Deposition of Group 2 Metal Oxides", INORGANIC CHEMISTRY, vol. 50, no. 24, 19 December 2011 (2011-12-19), pages 12396-12398, XP055067273, ISSN: 0020-1669, DOI: 10.1021/ic201751q

## Description

### BACKGROUND OF THE INVENTION

The semiconductor fabrication industry continues to source volatile metal containing precursors for vapor deposition processes, including chemical vapor deposition (CVD) and atomic layer deposition (ALD), for fabricating conformal metal containing films on substrates, such as silicon, metal nitride, metal oxide and other metal-containing layers, using these metal-containing precursors.

Precursors containing metals in group 2 of the periodic table (e.g. beryllium (Be), magnesium (Mg), calcium (Ca), strontium (Sr), barium (Ba), and radium (Ra)) are sought after in the semiconductor industry. For example, barium and strontium containing precursors are especially sought after for the deposition of thin barium and strontium oxide containing thin films, such as: strontium titanate (STO) and barium strontium titanate oxide (BST) for advanced memory device manufacture. Strontium precursors are also useful for the thin film deposition of ferroelectric materials of the type SrBi₂Ta₂O₉ for non-volatile memory, for the fabrication of thin film high temperature (Tc) superconductors of the type Bi₂Sr₂Caₙ₋₁CuₙO_{5+(2n-1)d} and for the manufacture of SrS:Ce and SrS:Cu phosphors for electroluminescent displays. Although there are fluorinated barium precursors which have excellent volatility, their use for BST manufacturing is effectively precluded, since fluoride ion can form in the oxide film and act as a charge carrier, which degrades the dielectric constant of the oxide film. Numerous strontium sources for strontium oxide and strontium titanate exist, but none of these sources can be used effectively for atomic layer deposition (ALD) processes which are used to deposit these films.

As previously mentioned, there is a strong need in the art for volatile unfluorinated barium and strontium precursor compounds with high ALD performance, but such compounds are scarce, especially barium. This stems from the large ionic radius of the barium +2 and strontium +2 ions requiring ionic ligands which can provide a coordinating environment sufficient to provide compounds which are monomeric or dimeric in strontium or barium. If this requirement is not met, the strontium, and especially the barium compounds, tend to form highly associated or polymeric structures of limited volatility. However, even if monomeric or dimeric structures can be achieved, these structures may still not possess the thermal stability required to survive the high sublimation or distillation temperatures required for their vaporization and to maintain their thermal stability when adsorbed as monolayers in an ALD process. For all of these reasons, unfluorinated barium and strontium precursors, which are monomeric or dimeric, themally stable, readily volatile and highly suited to BST and STO manufacture by ALD or CVD, are extremely scarce but highly sought after.

U.S. Publ. No. 2012/0035351 (corresponding to EP2371821) provides examples of sterically hindered imidazole ligands that are capable of coordinating to group 2 metals and precursors comprising same which are used to form BST films. Since it is highly desirable to deliver vapors of group 2 precursor by Direct Liquid Injection (DLI) for maximized wafer throughput and rapid ALD cycling, it is important that these precursors can be readily dissolved at high concentrations to create formulations suitable for DLI delivery. In addition, it is especially important that these formulations can be made using hydrocarbon solvents because these solvents can be readily dried to sub-ppm water levels. Also, hydrocarbon solvents are relatively inert towards ALD substrates compared to oxygen and nitrogen containing solvents which can potentially interact with surface reaction sites such as -OH thereby lowering the precursor's effective reactivity. The reference entitled "New Volatile Strontium and Barium Imidazolate Complexes for the Deposition of Group 2 Metal Oxides", J. A. T. Norman et al., Inorganic Chemistry, Vol. 50 (2011), pp. 12396-98 describes volatile group 2 imidazolates that are based upon tri-tert-butyl substituted imidazoles. In order to be useful for ALD or CVD deposition processes, it is important that this particular group of complexes can be rendered highly soluble in hydrocarbon solvents for DLI delivery. It is important to the end-user to have precursors which are readily deliverable to the reaction chamber. In this regard, it is highly desirable to deliver vapors of group 2 precursors by Direct Liquid Injection (DLI) for maximized wafer throughput and rapid ALD cycling.

### BRIEF SUMMARY OF THE INVENTION

Compositions comprising group 2 complexes having highly sterically hindered imidazole ligands are described herein which are useful for the DLI delivery of these precursors for vapor deposition processes such as atomic layer deposition (ALD) and chemical vapor deposition (CVD) growth of group 2 element containing films such as STO and BST. In order for these precursors to be delivered via DLI, these precursors should also be readily dissolved at a high enough concentration in order to form compositions suitable for DLI delivery. In addition, it is especially important that these compositions can be made using hydrocarbon solvents because these particular solvents can be readily dried to sub-parts per million (ppm) water levels. Further, hydrocarbon solvents are relatively inert towards substrates in ALD or CVD processes compared to oxygen and nitrogen containing solvents which can potentially interact with surface reaction sites such as hydroxyl (-OH) thereby lowering the precursor's effective reactivity. The compositions of group 2 imidazolate compounds described herein exhibit both volatility and thermal stability under conditions of vaporization. In addition, they are highly effective as precursors for STO and BST film growth and any other application which requires volatile sources of barium, strontium, magnesium, radium or calcium precursors.

A method is described for coordinating a neutral donor ligand selected from the group consisting of: furans, pyrrroles, imidazoles, pyrazoles, tetrazoles, pyrazoles, oxazoles, isoxazoles, thiazoles, isothiazoles, pyrazines, pyrimidines, pyrididazine, and pyridines to a group 2 tri-tert-alkylimidazolate complexes to provide an adduct complex comprising imidazolate anions wherein the imidazolate anions in the adduct complex are comprised of bis-eta 5 and are soluble in a hydrocarbon solvent to provide a composition.

In a first aspect, there is provided a composition comprising: a group 2 metal imidazolate complex comprising: an imidazolate comprising: at least one selected from the group consisting of: 2,4,5-tri-tert-butylimidazolate; 2-tert-butyl-4,5-di-(1,1-dimethylpropyl) imidazolate; 2-(1,1-dimethylbutyl)-4,5-di-tert-butylimidazolate; 2-(1,1-dimethylbutyl)-4,5-di-(1,1-dimethylpropyl)imidazolate; 2-tert-butyl-4,5-di-(1,1-dimethylbutyl)imidazolate; 2,4,5-tri-(1,1-dimethylbutyl)imidazolate; 2,4,5-tri-(1,1-dimethylpropyl)imidazolate; 2-(1,1-dimethylpropyl)-4,5-di-(1,1-dimethylbutyl)imidazolate; and 2-(1,1-dimethylpropyl)-4,5-di-tert-butylimidazolate; a group 2 metal selected from barium, strontium, magnesium, radium, and calcium; and a ligand which coordinates to the group 2 metal imidazolate complex wherein the ligand is at least one selected from the group consisting of a nitrogen-containing monodentate C₄ to C₁₂ cyclic molecule, an oxygen-containing monodentate C₄ to C₁₂ cyclic molecule, a nitrogen-containing C₄ to C₁₂ bidentate ligand, an oxygen-containing C₄ to C₁₂ bidentate ligand, and a C₄ to C₁₂ bidentate ligand comprising nitrogen and oxygen; and a hydrocarbon solvent having a boiling point of 100°C or greater.

In a still further aspect there is provided a method for forming a group 2 metal oxide film on a substrate wherein the film comprises a thickness, the method comprising:
a. introducing a group 2 metal containing composition comprising:
   a group 2 metal imidazolate complex comprising: an imidazolate comprising: at least one selected from the group consisting of: 2,4,5-tri-tert-butylimidazolate; 2-tert-butyl-4,5-di-(1,1-dimethylpropyl) imidazolate; 2-(1,1-dimethylbutyl)-4,5-di-tert-butylimidazolate; 2-(1,1-dimethylbutyl)-4,5-di-(1,1-dimethylpropyl)imidazolate; 2-tert-butyl-4,5-di-(1,1-dimethylbutyl)imidazolate; 2,4,5-tri-(1,1-dimethylbutyl)imidazolate; 2,4,5-tri-(1,1-dimethylpropyl)imidazolate; 2-(1,1-dimethylpropyl)-4,5-di-(1,1-dimethylbutyl)imidazolate; and 2-(1,1-dimethylpropyl)-4,5-di-tert-butylimidazolate; a group 2 metal selected from barium, strontium, magnesium, radium, and calcium; and a ligand which coordinates the group 2 metal to the imidazolate in the complex wherein the ligand is at least one selected from the group consisting of a nitrogen-containing monodentate C₄ to C₁₂ cyclic molecule, an oxygen-containing monodentate C₄ to C₁₂ cyclic molecule, a nitrogen-containing C₄ to C₁₂ bidentate ligand, an oxygen-containing C₄ to C₁₂ bidentate ligand, and a C₄ to C₁₂ bidentate ligand containing both nitrogen and oxygen; and
   a hydrocarbon solvent having a boiling point of 100°C or greater;
b. chemisorbing the group 2 metal containing composition onto the substrate;
c. purging away the unreacted group 2 metal containing composition using a purge gas;
d. providing an oxygen source to the group 2 metal containing composition onto the heated substrate to react with the sorbed the group 2 metal containing composition; and
e. optionally purging away any unreacted oxygen source.

### BRIEF DESCRIPTION OF SEVERAL VIEWS OF THE DRAWINGS

Figure 1 is an illustration of the X-ray structure of strontium bis(2,4,5-tri-tert-butylimidazolate)(tetrahydrofuran).
Figure 2 is an illustration of strontium bis(2,4,5-tri-tert-butylimidazolate)(3-methyl tetrahydrofuran).
Figure 3 is an illustration of the structure of strontium bis(2,4,5-tri-tert-butylimidazolate)(2,5-dihydrofuran).
Figure 4 is an illustration of strontium bis(2,4,5-tri-tert-butylimidazolate)(1,2-dimethoxypropane).
Figure 5 is an illustration of strontium bis(2,4,5-tri-tert-butylimidazolate)(1,1-dimethoxyethane).
Figure 6 is an illustration of strontium bis(2,4,5-tri-tert-butylimidazolate)(tetramethylethylenediamine).
Figure 7 is the thermogravimetric analysis (TGA)/differential scanning calorimetry (DSC) result for strontium bis(2,4,5-tri-tert-butylimidazolate)(tetrahydrofuran). TGA is a solid line and the DSC is a dashed line.

### DETAILED DESCRIPTION OF THE INVENTION

Described herein are compositions that overcome the inherently low solubility of tri-tert-butyl imidazole precursors in hydrocarbon solvents by first coordinating them to specific neutral ligands such as furans or other small heterocyclic ligands. The resulting compositions of group 2 imidazolate compounds disclosed herein allow them to be both volatile for deposition processes, more specifically atomic layer deposition processes, yet thermally stable under conditions of vaporization. In addition to the foregoing, the compounds or complexes and compositions comprising same are useful as precursors for STO and BST film growth and any other application which requires volatile sources of barium, strontium, magnesium, radium or calcium precursors.

Described herein is the coordination of a neutral ligand to a group 2 metal imidazolate dimer of the type shown in Formula 1 to yield monomeric complexes of the type shown in Formulae 2, 3 or 4. In Formula 2, L1 is coordinated to the metal center to yield a complex which contains two eta-5 coordinated imidazolate anions wherein each of the three carbon atoms and each of the two nitrogen atoms of both of the five-membered imidazolate anions are bonded to the metal. Examples of neutral ligand L1 include, but are not limited to, a nitrogen or oxygen containing monodentate C₄-C₁₂ cyclic molecules such as tetrahydrofuran, 3-methyltetrahydrofuran, 2,5-dihydrofuran, 2,3-dihydrofuran, pyridine, N-methylimidazole, and pyrrole. In Formula 3, L2 is coordinated to the metal center to yield a complex which contains one eta-1 imidazolate, where bonding to the metal occurs through only one imidazolate anion nitrogen atom, and one eta-5 imdazolate anion. Examples of neutral ligand L2 include, but are not limited to, C₄-C₁₂ nitrogen or oxygen containing bidentate ligands such as 1,1-dimethoxyethane, 1,2-dimethoxypropane. In Formula 4, L3 coordinates to the metal center to yield a complex which contains two eta-1 imidazolate anions. Examples of neutral ligand L3 include, but are not limited to, C₄-C₁₂ bidentate nitrogen containing ligands such as tetramethylethylenediamine. Unexpectedly, it is found that enhanced solubility in hydrocarbon solvents is observed only in the instances of bis eta-5 coordination of the type exemplified in Formula 2. While not wishing to be bound by theory, it is believed that in the bis eta-5 coordination cases the metal-imidazolate bonding is more covalent and less ionic in character versus the cases where one (Formula 3) or both (Formula 4) of the imidazolate anions are eta-1 where the metal-imidazolate bonding is more ionic and less covalent. Since solubility in hydrocarbon solvents is enhanced for covalent versus ionic molecules, the bis-eta-5 adduct complex precursors possess enhanced solubility compared to those having one eta-1 or two eta-1 imidazolate anions. In this regard, the solubility enhancement of bis eta-5 adduct complex precursors is about 8-10 times that of the parent precursors (e.g. the group 2 metal imidazolate dimer having Formula 1). In Formulae 1, 2, 3 and 4 shown below, the bulky alkyl substituent groups (R¹, R² and R³ wherein R¹, R², and R³ are independently selected from C₃-₁₂ branched alkyl) on the three ring carbon atoms of the imidazolate anion have been omitted for clarity.

These bulky alkyl groups substituted on each of the three carbon atoms of the imidazolate anions are tertiary groups, preferably tert-butyl groups. The imidazole positions are conventionally numbered i.e. the nitrogens are positions 1 and 3, the carbon between the nitrogens is position 2, and the remaining carbons are positions 4 and 5.

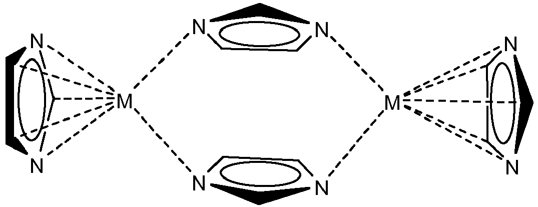

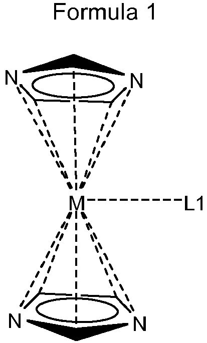

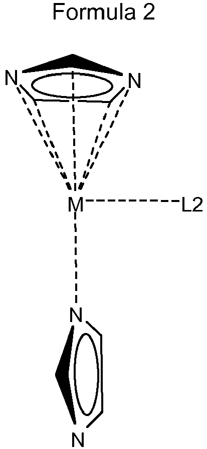

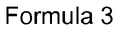

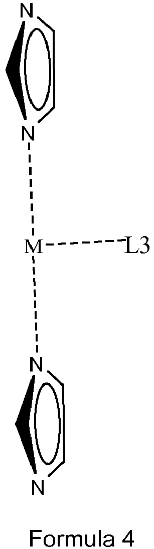

The solubilities of strontium bis(2,4,5-tri-tert-butylimidazolate)(L) adducts in the solvents cyclooctane and mesitylene are shown below in Tables 1 and 2 respectively. Solubility was determined by taking a weighed amount of solvent at room temperature, incrementally adding metal complex with mixing until no more could be dissolved then reweighing the resultant solution to permit the weight percentage of metal complex dissolved to be calculated. A fixed volume of the solution was then weighed. From this weight, the weight of metal complex and hence moles of metal complex dissolved is calculated. The moles of metal complex is then divided by the volume of weighed solution in liters to yield the molarity of the solution. Referring to Tables 1 and 2, strontium bis(2,4,5-tri-tert-butylimidazolate)(tetrahydrofuran), strontium bis(2,4,5-tri-tert-butylimidazolate)(3-methyltetrahydrofuran), and strontium bis(2,4,5-tri-tert-butylimidazolate)(2,5-dihydrofuran), all of which have bis eta-5 coordination of imidazolate of the type shown in Formula 2, are 9 to 13 times more soluble in the solvent mesitylene than their parent complex di-strontium tetra(2,4,5-tri-tert-butylimidazolate) and with the exception of the complex bis(2,4,5-tri-tert-butylimidazolate)(3-methyltetrahydrofuran), are also 11 to 12 times more soluble in cyclooctane than their parent complex. The other examples represented by Formula 3 are slightly more soluble than the parent complex and the example of Formula 4 is slightly less soluble than the parent complex. Additionally, simple ethers such as di-n-butylether are shown to not form a complex with di-strontium tetra(2,4,5-tri-tert-butylimidazolate), as exemplified in Example 7 described herein, underscoring the fact that not all neutral ligand molecules can coordinate to form a complex, let alone form a bis-eta 5 imidazolate complex. Therefore it is apparent that only a select type of neutral ligand will coordinate to a group 2 imidazolate to form a complex and within that group of neutral ligands, only a select group will form complexes with bis eta-5 imidazolate coordination to the group 2 metal to yield the highest solubilities in hydrocarbon solvents.

**Table 1: Solubilities of strontium imidazolate adducts in cyclooctane**

| Strontium complex | Wt% of strontium complex | Molarity of strontium complex | Type of structure |
|---|---|---|---|
| di-strontium tetra(2,4,5-tri-tert-butylimidazolate) (comparative) | 1.7 | 0.03M | Formula 1 |
| Strontium bis(2,4,5-tri-tert-butylimidazolate)(tetrahydrofuran) | 23.6 | 0.35M | Formula 2 |
| Strontium bis(2,4,5-tri-tert-butylimidazolate)(3-methyltetrahydrofuran) | 3.5 | 0.05M | Formula 2 |
| Strontium bis(2,4,5-tri-tert-butylimidazolate)(2,5-dihydrofuran) | 24 | 0.37M | Formula 2 |
| Strontium bis(2,4,5-tri-tert-butylimidazolate)(1,2-dimethoxypropane) | 2.8 | 0.04M | Formula 3 |
| Strontium bis(2,4,5-tri-tert-butylimidazolate)(1,1-dimethoxyethane) | 2.1 | 0.03M | Formula 3 |
| Strontium bis(2,4,5-tri-tert-butylimidazolate)(tetramethylethylenediamine) | 1.8 | 0.02M | Formula 4 |

**Table 2: Solubilities of strontium imidazolate adducts in mesitylene.**

| Strontium complex | Wt% of strontium complex | Molarity of strontium complex | Type of structure |
|---|---|---|---|
| di-strontium tetra(2,4,5-tri-tert-butylimidazolate) (comparative) | 3.6 | 0.049M | Formula 1 |
| Strontium bis(2,4,5-tri-tert-butylimidazolate)(tetrahydrofuran) | 28.2 | 0.6M | Formula 2 |
| Strontium bis(2,4,5-tri-tert-butylimidazolate)(3-methyltetrahydrofuran) | 28.8 | 0.44M | Formula 2 |
| Strontium bis(2,4,5-tri-tert-butylimidazolate)(2,5-dihydrofuran) | 38 | 0.64M | Formula 2 |
| Strontium bis(2,4,5-tri-tert-butylimidazolate)(1,2-dimethoxypropane) | 7.3 | 0.093M | Formula 3 |
| Strontium bis(2,4,5-tri-tert-butylimidazolate)(1,1-dimethoxyethane) | 9.0 | 0.13M | Formula 3 |
| Strontium bis(2,4,5-tri-tert-butylimidazolate)(tetramethylethylenediamine) | 3.3 | 0.041 M | Formula 4 |

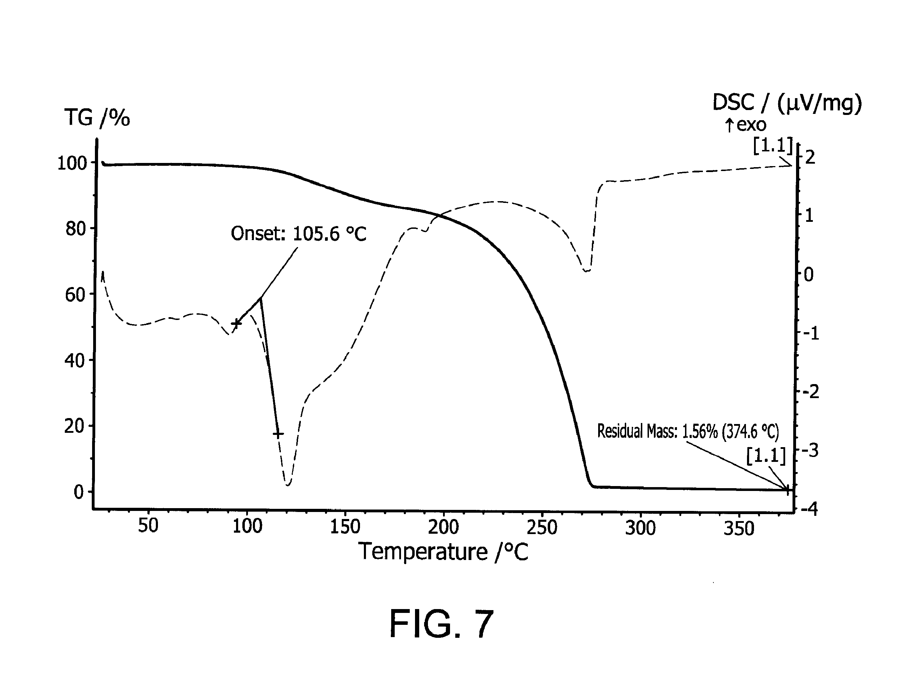

Thermogravimetric analysis (TGA) of the complexes listed in Tables 1 and 2 were conducted whereby samples were suspended in a microbalance pan under a steady stream of nitrogen while being heated under a constant rate. Weight loss is measured as a function of temperature/ time while a differential scanning calorimeter monitors exotherms (decomposition) or endotherms (phase change/melting or evaporative cooling). The TGA results from the above adduct complex precursors show that the initial weight loss due to the evaporation of coordinated neutral ligands begins at temperatures that are significantly higher than the boiling points of the ligands themselves. For a representative example, in the case of bis(2,4,5-tri-tert-butylimidazolate)(tetrahydrofuran), Figure 7, the initial decreases in weight loss associated with the loss of tetrahydrofuran significantly begins at a temperature of about 100°C or greater compared to the boiling point of 65°C for pure tetrahydrofuran. Thus, while not wishing to be bound by theory, it is believed that the coordinated ligands are coordinated with sufficient affinity that they can at least partially co-evaporate with the strontium precursor under these TGA conditions and hence comparable performance can be anticipated in a DLI system using compositions of these precursors dissolved in hydrocarbon solvents such as cyclooctane or mesitylene, preferrably using precursors of the type shown in Formula 2.

In other experiments, the inventors have found that di-strontium tetra(2,4,5-tri-tert-butylimidazolate) can readily form a 0.3M solution at 70°C in cyclooctane, compared to its saturated concentration of 0.03M at room temperature. Thus, even if all of the coordinated tetrahydrofuran was evaporatively lost from a 0.3M of strontium bis(2,4,5-tri-tert-butylimidazolate)(tetrahydrofuran) in cyclooctane during DLI evaporation as the solution reached 70°C in the vaporizer, the residual di-strontium tetra(2,4,5-tri-tert-butylimidazolate) thus formed would remain in solution. However, the TGA in Figure 7 indicates that tetrahydrofuran is not lost until approximately 100°C at which point the solubility of di-strontium tetra(2,4,5-tri-tert-butylimidazolate) in cyclooctane would be expected to exceed 0.3M. While not wishing to be bound by theory, these result indicates that the precursor would not precipitate, but rather would remain dissolved during its coevaporation with the hydrocarbon solvent.

Described herein are compositions comprising compounds having one or more polysubstituted imidazolate anions coordinated to a metal selected from the group consisting of barium, strontium, magnesium, calcium or radium or mixtures thereof. The resulting complex is then coordinated to a neutral donor ligand such as an ether or amine or any of the other ligands defined herein to form a new more soluble complex which is then dissolved into a suitable solvent and the resulting composition used for DLI. Compositions described herein combined with other metal complexes are also contemplated where the additional metal complex can be a titanium imidazolate complex or a non-imidazolate complex including where the complexes are also dissolved in a solvent and the resulting composition used in DLI mode. Particularly useful combinations would include those where a strontium imidazole is combined with a titanium complex so as to provide such a composition or co-dissolved in a suitable solvent to form a composition suitable for use as a DLI composition for STO, BST or BTO by ALD or CVD thin film Group 2 containing metal thin film deposition. Similarly, compositions comprising strontium and barium imidazolate complexes can be combined with suitable titanium complexes for BST film growth.

Alternatively, in these compositions one imidazolate anion can be substituted with a second non-imidazolate anion. In addition, the imidazolate anion may also bear a substituent, which is also deprotonated to yield a dianionic species, and this dianion is coordinated to a metal, such as barium, strontium, magnesium, calcium or radium or mixtures thereof.

Preferably, the second non-imidazolate anion is selected from the group consisting of polysubstituted imidazolate anion, polyalkylated pyrrolyl anion, beta-diketonates, acetates, ketoiminates, diimines, alkoxides, amides, hydrides, beta-ketoesters, amidinates, guanidinates, cyclopentadienyl, cyanide, isocyanide, formate, oxalate, malonate, phenoxide, thiolate, sulfide, nitrate, alkyl, silylalkyl, fluoroalkyl, aryl, imidazolate, hydride and mixtures thereof.

The direct synthesis of the novel DLI formulations disclosed herein is also described where the imidazole ligand is reacted with a group 2 source reagent in the DLI solvent in the presence of the coordinating donor ligand compounds.

The use of the barium and strontium imidazolate based DLI formulations disclosed herein is described for the manufacture of of BST and STO films.

Preferred compositions for DLI contain metal imidazolates which include; calcium bis(2,4,5-tri-tert-butylimidazolate)(tetrahydrofuran),strontium bis(2,4,5-tri-tert-butylimidazolate)(tetrahydrofuran), barium bis(2,4,5-tri-tert-butylimidazolate)(tetrahydrofuran), calcium bis(2,4,5-tri-tert-butylimidazolate)(3-methyl tetrahydrofuran),strontium bis(2,4,5-tri-tert-butylimidazolate)(3-methyl tetrahydrofuran), barium bis(2,4,5-tri-tert-butylimidazolate)(3-methyltetrahydrofuran), calcium bis(2,4,5-tri-tert-butylimidazolate)(2,5-dihydrofuran), strontium bis(2,4,5-tri-tert-butylimidazolate)(2,5-dihydrofuran), barium bis(2,4,5-tri-tert-butylimidazolate)(2,5-dihydrofuran), calcium bis(2,4,5-tri-tert-butylimidazolate)(2,3-dihydrofuran), strontium bis(2,4,5-tri-tert-butylimidazolate)(2,3-dihydrofuran), and barium bis(2,4,5-tri-tert-butylimidazolate)( 2,3-dihydrofuran).

Preferred compositions for DLI contain the metal imidazolates which include; calcium bis(2-tert-butyl-4,5-di-(1,1-dimethylpropyl)imidazolate)(tetrahydrofuran), strontium bis(2-tert-butyl-4,5-di-(1,1-dimethylpropyl)imidazolate)(tetrahydrofuran), barium bis(2-tert-butyl-4,5-di-(1,1-dimethylpropyl)imidazolate)(tetrahydrofuran), calcium bis(2-tert-butyl-4,5-di-(1,1-dimethylpropyl)imidazolate)(3-methyltetrahydrofuran), strontium bis(2-tert-butyl-4,5-di-(1,1-dimethylpropyl)imidazolate)(3-methyl tetrahydrofuran), barium bis(2-tert-butyl-4,5-di-(1,1-dimethylpropyl)imidazolate)(3-methyl tetrahydrofuran), calcium bis(2-tert-butyl-4,5-di-(1,1-dimethylpropyl)imidazolate)(2,5-dihydrofuran), strontium bis(2-tert-butyl-4,5-di-(1,1-dimethylpropyl)imidazolate)(2,5-dihydrofuran), barium bis(2-tert-butyl-4,5-di-(1,1-dimethylpropyl)imidazolate)(2,5-dihydrofuran), calcium bis(2-tert-butyl-4,5-di-(1,1-dimethylpropyl)imidazolate)(2,3-dihydrofuran), strontium bis(2-tert-butyl-4,5-di-(1,1-dimethylpropyl)imidazolate)(2,3-dihydrofuran), and barium bis(2-tert-butyl-4,5-di-(1,1-dimethylpropyl)imidazolate)(2,3-dihydrofuran).

Preferred compositions for DLI contain the metal imidazolates which include; calcium bis(2-tert-butyl-4,5-di-(1,1-dimethylbutyl)imidazolate)(tetrahydrofuran), strontium bis(2-tert-butyl-4,5-di-(1,1-dimethylbutyl)imidazolate)(tetrahydrofuran), barium bis(2-tert-butyl-4,5-di-(1,1-dimethylbutyl)imidazolate)(tetrahydrofuran), calcium bis(2-tert-butyl-4,5-di-(1,1-dimethylbutyl)imidazolate)(3-methyl tetrahydrofuran), strontium bis(2-tert-butyl-4,5-di-(1,1-dimethylbutyl)imidazolate)(3-methyl tetrahydrofuran), barium bis(2-tert-butyl-4,5-di-(1,1-dimethylbutyl)imidazolate)(3-methyl tetrahydrofuran), calcium bis(2-tert-butyl-4,5-di-(1,1-dimethylbutyl)imidazolate)(2,5-dihydrofuran), strontium bis(2-tert-butyl-4,5-di-(1,1-dimethylbutyl)imidazolate)(2,5-dihydrofuran), barium bis(2-tert-butyl-4,5-di-(1,1-dimethylbutyl)imidazolate)(2,5-dihydrofuran), calcium bis(2-tert-butyl-4,5-di-(1,1-dimethylbutyl)imidazolate)(2,3-dihydrofuran), strontium bis(2-tert-butyl-4,5-di-(1,1-dimethylbutyl)imidazolate)(2,3-dihydrofuran), and barium bis(2-tert-butyl-4,5-di-(1,1-dimethylbutyl)imidazolate)(2,3-dihydrofuran).

Preferred compositions for DLI contain the metal imidazolates which include; calcium bis(2,4,5-tri-(1,1-dimethylbutyl)imidazolate)(tetrahydrofuran), strontium bis(2,4,5-tri-(1,1-dimethylbutyl)imidazolate)(tetrahydrofuran), barium bis(2,4,5-tri-(1,1-dimethylbutyl)imidazolate)(tetrahydrofuran), calcium bis(2,4,5-tri-(1,1-dimethylbutyl)imidazolate)(3-methyl tetrahydrofuran), strontium bis(2,4,5-tri-(1,1-dimethylbutyl)imidazolate)(3-methyl tetrahydrofuran), barium bis(2,4,5-tri-(1,1-dimethylbutyl)imidazolate)(3-methyl tetrahydrofuran), calcium bis(2,4,5-tri-(1,1-dimethylbutyl)imidazolate)(2,5-hydrofuran), strontium bis(2,4,5-tri-(1,1-dimethylbutyl)imidazolate)(2,5-hydrofuran), barium bis(2,4,5-tri-(1,1-dimethylbutyl)imidazolate (2,5-dihydrofuran), calcium bis(2,4,5-tri-(1,1-dimethylbutyl)imidazolate)(2,3-dihydrofuran), strontium bis(2,4,5-tri-(1,1-dimethylbutyl)limidazolate)(2,3-dihydrofuran), and barium bis(2,4,5-tri-(1,1-dimethylbutyl) imidazolate) (2,3-dihydrofuran).

Preferred compositions for DLI contain the metal imidazolates which include; calcium bis(2-(1,1-dimethylbutyl)-4,5-di-(1,1-dimethylpropyl)imidazolate) (tetrahydrofuran), strontium bis(2-(1,1-dimethylbutyl) -4,5-di-(1,1-dimethylpropyl)imidazolate)(tetrahydrofuran), barium bis(2-(1,1-dimethylbutyl) -4,5-di-(1,1-dimethylpropyl)imidazolate)(tetrahydrofuran), calcium bis(2-(1,1-dimethylbutyl)-4,5-di-(1,1-dimethylpropyl))imidazolate)(3-methyl tetrahydrofuran), strontium bis(2-(1,1-dimethylbutyl)-4,5-di-(1,1-dimethylpropyl))imidazolate)(3-methyl tetrahydrofuran), barium bis(2-(1,1-dimethylbutyl)-4,5-di-(1,1-dimethylpropyl)imidazolate (3-methyl tetrahydrofuran), calcium bis(2-(1,1-dimethylbutyl)-4,5-di-(1,1-dimethylpropyl)imidazolate)(2,5-dihydrofuran), strontium bis(2-(1,1-dimethylbutyl) -4,5-di-(1,1-dimethylpropyl)imidazolate)(2,5-dihydrofuran), barium bis(2-(1,1-dimethylbutyl)-4,5-di-(1,1-dimethylpropyl)imidazolate)(2,5-dihydrofuran), calcium bis(2-(1,1-dimethylbutyl)-4,5-di-(1,1-dimethylpropyl)imidazolate)(2,3-dihydrofuran), strontium bis(2-(1,1-dimethylbutyl)-4,5-di-(1,1-dimethylpropyl)imidazolate)(2,3-dihydrofuran), and barium bis(2-(1,1-dimethylbutyl)-4,5-di-(1,1-dimethylpropyl)imidazolate)(2,3-dihydrofuran).

Preferred compositions for DLI contain the metal imidazolates which include; calcium bis(2,4,5-tri-(1,1-dimethylbutyl)imidazolate)) (tetrahydrofuran), strontium bis(2,4,5-tri-(1,1-dimethylbutyl)imidazolate) (tetrahydrofuran), barium bis(2,4,5-tri-(1,1-dimethylbutyl)imidazolate) (tetrahydrofuran), calcium bis(2,4,5-tri-(1,1-dimethylbutyl)imidazolate)(3-methyltetrahydrofuran),strontium bis(2,4,5-tri-(1,1-dimethylbutyl)imidazolate)(3-methyltetrahydrofuran), barium bis(2,4,5-tri-(1,1-dimethylbutyl)imidazolate)(3-methyl tetrahydrofuran), calcium bis(2,4,5-tri-(1,1-dimethylbutyl)imidazolate)(2,5-dihydrofuran), strontium bis(2,4,5-tri-(1,1-dimethylbutyl)imidazolate)(2,5-dihydrofuran), barium bis(2,4,5-tri-(1,1-dimethylbutyl)imidazolate) (2,5-dihydrofuran), calcium bis(2,4,5-tri-(1,1-dimethylbutyl)imidazolate)(2,3-dihydrofuran), strontium bis(2,4,5-tri-(1,1-dimethylbutyl)imidazolate)(2,3-dihydrofuran), and barium bis(2,4,5-tri-(1,1-dimethylbutyl)imidazolate)(2,3-dihydrofuran).

Preferred compositions for DLI contain the metal imidazolates which include calcium bis(2-(1,1-dimethylpropyl)-4,5-di-(1,1-dimethylbutyl)imidazolate)(tetrahydrofuran), strontium bis(2-(1,1-dimethylpropyl)-4,5-di-(1,1-dimethylbutyl)imidazolate)(tetrahydrofuran), barium bis(2-(1,1-dimethylpropyl)-4,5-di-(1,1-dimethylbutyl)imidazolate)(tetrahydrofuran), calcium bis(2-(1,1-dimethylpropyl)-4,5-di-(1,1-dimethylbutyl)imidazolate)(3-methyltetrahydrofuran), strontium bis(2-(1,1-dimethylpropyl)-4,5-di-(1,1-dimethylbutyl)imidazolate)(3-methyltetrahydrofuran), barium bis(2-(1,1-dimethylpropyl)-4,5-di-(1,1-dimethylbutyl)imidazolate)(3-methyltetrahydrofuran), calcium bis(2-(1,1-dimethylpropyl)-4,5-di-(1,1-dimethylbutyl)imidazolate)(2,5-dihydrofuran), strontium bis(2-(1,1-dimethylpropyl)-4,5-di-(1,1-dimethylbutyl)imidazolate)(2,5-dihydrofuran), barium bis(2-(1,1-dimethylpropyl)-4,5-di-(1,1-dimethylbutyl)imidazolate)(2,5-dihydrofuran), calcium bis(2-(1,1-dimethylpropyl)-4,5-di-(1,1-dimethylbutyl)imidazolate)(2,3-dihydrofuran), strontium bis(2-(1,1-dimethylpropyl)-4,5-di-(1,1-dimethylbutyl)imidazolate)(2,3-dihydrofuran), and barium bis(2-(1,1-dimethylpropyl)-4,5-di-(1,1-dimethylbutyl)imidazolate)(2,3-dihydrofuran).

Preferred compositions for DLI contain the metal imidazolates which include calcium bis(2,4,5-tri-(1,1-dimethylpropyl)imidazolate)(tetrahydrofuran), strontium bis(2,4,5-tri-(1,1-dimethylpropyl)imidazolate)(tetrahydrofuran), barium bis(2,4,5-tri-(1,1-dimethylpropyl)imidazolate)(tetrahydrofuran), calcium bis(2,4,5-(1,1-dimethylpropyl)imidazolate)(3-methyltetrahydrofuran), strontium bis(2,4,5-tri-(1,1-dimethylpropyl)imidazolate)(3-methyltetrahydrofuran), barium bis(2,4,5-tri-(1,1-dimethylpropyl)imidazolate)(3-methyltetrahydrofuran), calcium bis(2,4,5-tri-(1,1-dimethylpropyl) imidazolate)(2,5-dihydrofuran), strontium bis(2,4,5-tri-(1,1-dimethylpropyl)imidazolate)(2,5-dihydrofuran), barium bis(2,4,5-tri-(1,1-dimethylpropyl)imidazolate)(2,5-dihydrofuran), calcium bis(2,4,5-tri-(1,1-dimethylpropyl)-imidazolate)(2,3-dihydrofuran), strontium bis(2,4,5-tri-(1,1-dimethylpropyl)imidazolate)(2,3-dihydrofuran), and barium bis(2,4,5-tri-(1,1-dimethylpropyl)imidazolate)(2,3-dihydrofuran).

Preferred compositions for DLI contain the metal imidazolates which include calcium bis(2-(1,1-dimethylpropyl)-4,5-di-tert-butylimidazolate)(tetrahydrofuran), strontium bis(2-(1,1-dimethylpropyl)-4,5-di-tert-butylimidazolate)(tetrahydrofuran), barium bis(2-(1,1-dimethylpropyl)-4,5-di-tert-butylimidazolate)(tetrahydrofuran), calcium bis(2-(1,1-dimethylpropyl)-4,5-di-tert-butylimidazolate)(3-methyltetrahydrofuran), strontium bis(2-(1,1-dimethylpropyl)-4,5-di-tert-butylimidazolate)(3-methyltetrahydrofuran), barium bis(2-(1,1-dimethylpropyl)-4,5-di-tert-butylimidazolate)(3-methyltetrahydrofuran), calcium bis(2-(1,1-dimethylpropyl)-4,5-di-tert-butylimidazolate)(2,5-dihydrofuran), strontium bis(2-(1,1-dimethylpropyl)-4,5-di-tert-butylimidazolate)(2,5-dihydrofuran), barium bis(2-(1,1-dimethylpropyl)-4,5-di-tert-butylimidazolate)(2,5-dihydrofuran), calcium bis(2-(1,1-dimethylpropyl)-4,5-di-tert-butylimidazolate)(2,3-dihydrofuran), strontium bis(2-(1,1-dimethylpropyl)-4,5-di-tert-butylimidazolate)(2,3-dihydrofuran), and barium bis(2-(1,1-dimethylpropyl)-4,5-di-tert-butylimidazolate)(2,3-dihydrofuran).

Preferably, the present invention's metal imidazolates compositions are contained in a stainless steel container. More preferably, the stainless steel container is electropolished in its interior. Most preferably, the stainless steel container is outfitted with inlet and outlet valves for high purity and low dead space service.

Currently, a major use of ALD in the semiconductor industry is the growth of metal oxide films, such as: strontium oxide, barium oxide and the perovskite oxides: strontium titanate (STO) and barium titanate (BST). Often, these processes are required to grow perfectly conformal films into deeply bored cyclindrical volumes (vias) or over columnar structures (pillars), where it is imperative that there is no thermal decomposition or CVD component that will degrade conformality.

Beside the requirements of the group 2 imidazolate precursors delivered by DLI to be thermally stable to preclude deposition by CVD, they also need to maintain high chemical reactivity under ALD conditions. Since reactive sites on the ALD substrate such as surface -OH can interact with oxygen and nitrogen containing solvents, these solvents have the potential to lower the precursor's effective reactivity. Thus, hydrocarbon solvents are used, underscoring the need to use precursors which are highly soluble in hydrocarbons. In addition, the hydrocarbon solvents can be readily dried to sub ppm levels of water to prevent any hydrolysis of the precursor from occurring which can lead to the formation of insoluble by-products which can clog and obstruct the finely bored evaporation nozzles of DLI systems delivery.

The imidazoles can then be deprotonated to yield their respective imidazolate anions, which can then coordinate to barium, strontium, calcium or radium ions to, in turn, yield their respective complexes. The adduct complexes described herein may be synthesized directly in this step by forming the metal complex in the presence of the donor ligand.

In certain embodiments, the imidazolate is one selected from the group consisting of 2,4,5-tri-tert-butylimidazolate; 2-tert-butyl-4,5-di-(1,1-dimethylpropyl) imidazolate; 2-(1,1-dimethylbutyl)-4,5-di-tert-butylimidazolate; 2-(1,1-dimethylbutyl)-4,5-di-(1,1-dimethylpropyl)imidazolate; and their barium, strontium, magnesium and calcium compounds.

Synthesis of the novel compounds or complexes and their use to form BST films is also described.

The group 2 metal containing compositions described herein are highly suitable for use as volatile precursors for ALD, CVD, pulsed CVD, plasma enhanced ALD (PEALD) or plasma enhanced CVD (PECVD) for the manufacture of semiconductor type microelectronic devices, such as microcapacitor cells for memory applications such as DRAM devices. They are also highly useful for the manufacture of pyrodetector devices. The method used to form the metal-containing films or coatings are deposition processes. Examples of suitable deposition processes for the method disclosed herein include, but are not limited to, cyclic CVD (CCVD), MOCVD (Metal Organic CVD), thermal chemical vapor deposition, plasma enhanced chemical vapor deposition ("PECVD"), high density PECVD, photon assisted CVD, plasma-photon assisted CVD ("PPACVD"), cryogenic chemical vapor deposition, chemical assisted vapor deposition, hot-filament chemical vapor deposition, CVD of a liquid polymer precursor, deposition from supercritical fluids, and low energy CVD (LECVD). In certain embodiments, the metal containing films are deposited via atomic layer deposition (ALD), plasma enhanced ALD (PEALD) or plasma enhanced cyclic CVD (PECCVD) process. As used herein, the term "chemical vapor deposition processes" refers to any process wherein a substrate is exposed to one or more volatile precursors, which react and/or decompose on the substrate surface to produce the desired deposition. As used herein, the term "atomic layer deposition process" refers to a self-limiting (e.g. the amount of film material deposited in each reaction cycle is constant), sequential surface chemistry that deposits films of materials onto substrates of varying compositions. Although the precursors, reagents and sources used herein may be sometimes described as "gaseous", it is understood that the precursors can be either liquid or solid which are transported with or without an inert gas into the reactor via direct vaporization, bubbling or sublimation. In some case, the vaporized precursors can pass through a plasma generator. In one embodiment, the metal-containing film is deposited using an ALD process. In another embodiment, the metal-containing film is deposited using a CCVD process. In a further embodiment, the metal-containing film is deposited using a thermal CVD process. The term "reactor" as used herein, includes without limitation, reaction chamber or deposition chamber.

In certain embodiments, the method disclosed herein avoids pre-reaction of the metal precursors by using ALD or CCVD methods that separate the precursors prior to and/or during the introduction to the reactor. In this connection, deposition techniques such as ALD or CCVD processes are used to deposit the dielectric film. In one embodiment, the film is deposited via an ALD process by exposing the substrate surface alternatively to the one or more the group 2 metal containing composition, oxygen source, or other precursor or reagent. Film growth proceeds by self-limiting control of surface reaction, the pulse length of each precursor or reagent, and the deposition temperature. However, once the surface of the substrate is saturated, the film growth ceases.

Depending upon the deposition method, in certain embodiments, the one or more, group 2 metal precursors may be introduced into the reactor at a predetermined molar volume, or from about 0.1 to about 1000 micromoles. In this or other embodiments, the group 2 metal precursor may be introduced into the reactor for a predetermined time period. In certain embodiments, the time period ranges from about 0.001 to about 500 seconds.

In certain embodiments, the films deposited using the methods described herein are formed in the presence of oxygen using an oxygen source, reagent or precursor comprising oxygen. An oxygen source may be introduced into the reactor in the form of at least one oxygen source and/or may be present incidentally in the other precursors used in the deposition process. Suitable oxygen source gases may include, for example, water (H₂O) (e.g. deionized water, purifier water, and/or distilled water), oxygen (O₂), oxygen plasma, ozone (O₃), NO, NO₂, carbon monoxide (CO), carbon dioxide (CO₂) and combinations thereof. In certain embodiments, the oxygen source comprises an oxygen source gas that is introduced into the reactor at a flow rate ranging from about 1 to about 2000 standard cubic centimeters per minute (sccm) or from about 1 to about 1000 sccm. The oxygen source can be introduced for a time that ranges from about 0.1 to about 100 seconds. In one particular embodiment, the oxygen source comprises water having a temperature of 10°C or greater. In embodiments wherein the film is deposited by an ALD or a cyclic CVD process, the precursor pulse can have a pulse duration that is greater than 0.01 seconds, and the oxygen source can have a pulse duration that is less than 0.01 seconds, while the water pulse duration can have a pulse duration that is less than 0.01 seconds. In yet another embodiment, the purge duration between the pulses that can be as low as 0 seconds or is continuously pulsed without a purge in-between.

The deposition methods disclosed herein may involve one or more purge gases. The purge gas, which is used to purge away unconsumed reactants and/or reaction byproducts, is an inert gas that does not react with the precursors. Exemplary purge gases include, but are not limited to, argon (Ar), nitrogen (N₂), helium (He), neon, hydrogen (H₂), and mixtures thereof. In certain embodiments, a purge gas such as Ar is supplied into the reactor at a flow rate ranging from about 10 to about 2000 sccm for about 0.1 to 1000 seconds, thereby purging the unreacted material and any byproduct that may remain in the reactor.

The respective step of supplying the precursors, oxygen source, and/or other precursors, source gases, and/or reagents may be performed by changing the time for supplying them to change the stoichiometric composition of the resulting film.

Energy is applied to the at least one of the precursor, oxygen-containing source, reducing agent, other precursors or combination thereof to induce reaction and to form the metal-containing film or coating on the substrate. Such energy can be provided by, but not limited to, thermal, plasma, pulsed plasma, helicon plasma, high density plasma, inductively coupled plasma, X-ray, e-beam, photon, remote plasma methods, and combinations thereof. In certain embodiments, a secondary RF frequency source can be used to modify the plasma characteristics at the substrate surface. In embodiments wherein the deposition involves plasma, the plasma-generated process may comprise a direct plasma-generated process in which plasma is directly generated in the reactor, or alternatively a remote plasma-generated process in which plasma is generated outside of the reactor and supplied into the reactor.

The group 2 metal precursors may be delivered to the reaction chamber such as a CVD or ALD reactor in a variety of ways. In one embodiment, a liquid delivery system may be utilized. In an alternative embodiment, a combined liquid delivery and flash vaporization process unit may be employed, such as, for example, the turbo vaporizer manufactured by MSP Corporation of Shoreview, MN, to enable low volatility materials to be volumetrically delivered, which leads to reproducible transport and deposition without thermal decomposition of the precursor. The precursor compositions described in this application can be effectively used as source reagents in DLI mode to provide a vapor stream of these Group 2 imidazolate precursors into an ALD or CVD reactor. These compositions use hydrocarbon solvents which are particularly desirable due to their ability to be dried to sub-ppm levels of water. Exemplary hydrocarbon solvents that can be used in the present invention include, but are not limited to, toluene, mesitylene, cumene (isopropylbenzene), p-cymene (4-isopropyl toluene), 1,3-diisopropylbenzene, octane, dodecane, 1,2,4-trimethylcyclohexane, n-butylcyclohexane, and decahydronaphthalene (decalin). The precursor compositions of this application can also be stored and used in stainless steel containers.. The group 2 imidazolate DLI precursor compositions of this application can also be mixed with other suitable metal precursors, and the mixture used to deliver both metals simultaneously for the growth of a binary metal oxide or nitride films. For example, the strontium precursors of this disclosure can be mixed with suitable titanium precursors, including imidazolate based titanium precursors, for the growth of strontium titanate (STO) films. Similarly, barium precursors of this disclosure can be mixed with suitable strontium precursors, including imadazolate based strontium precursors, then mixed with suitable titanium precursors, including imidazolate precursors, for the growth of barium strontium titanate (BST) films. Similarly, barium precursors of this disclosure can be be mixed with suitable titanium precursors, including imidazolate based titanium precursors, for the growth of barium titanate (BTO) thin films.

In certain embodiments, the purity level of the precursor compositions are sufficiently high enough to be acceptable for reliable semiconductor manufacturing. In certain embodiments, the group 2 metal-containing precursors and compositions comprising same described herein comprise less than 2% by weight, or less than 1% by weight, or less than 0.5% by weight of one or more of the following impurities: free amines, free halides or an halogen ion, and higher molecular weight species. Higher purity levels of the group 2 metal-containing precursors described herein can be obtained through one or more of the following processes: purification, adsorption, and/or distillation.

In certain embodiments, the gas lines connecting from the precursor canisters to the reaction chamber are heated to one or more temperatures depending upon the process requirements and the container comprising the composition is kept at one or more temperatures for bubbling. In other embodiments, a composition comprising the group 2 metal-containing precursor is injected into a vaporizer kept at one or more temperatures for direct liquid injection.

A flow of argon and/or other gas may be employed as a carrier gas to help deliver the vapor of the at least one group 2 metal-containing precursor to the reaction chamber during the precursor pulsing. In certain embodiments, the reaction chamber process pressure is about 1 Torr (130 Pa).

In a typical ALD or CCVD process, the substrate such as a silicon oxide substrate is heated on a heater stage in a reaction chamber that is exposed to the group 2 metal-containing precursor initially to allow the complex to chemically adsorb onto the surface of the substrate.

A purge gas such as argon purges away unabsorbed excess complex from the process chamber. After sufficient purging, a nitrogen-containing source may be introduced into reaction chamber to react with the absorbed surface followed by another gas purge to remove reaction by-products from the chamber. The process cycle can be repeated to achieve the desired film thickness.

In certain embodiments, the process employs a reducing agent. The reducing agent is typically introduced in gaseous form. Examples of suitable reducing agents include, but are not limited to, hydrogen gas, hydrogen plasma, remote hydrogen plasma, silanes (e.g. diethylsilane, ethylsilane, dimethylsilane, phenylsilane, silane, disilane, aminosilanes, chlorosilanes), boranes (e.g. borane, diborane), alanes, germanes, hydrazines, ammonia, or mixtures thereof. In one particular embodiment such as the deposition of amorphous silicon, a reducing agent is used.

In this or other embodiments, it is understood that the steps of the methods described herein may be performed in a variety of orders, may be performed sequentially or concurrently (e.g. during at least a portion of another step), and any combination thereof. The respective step of supplying the precursors and the nitrogen-containing source gases may be performed by varying the duration of the time for supplying them to change the stoichiometric composition of the resulting dielectric film.

In another embodiment of the method disclosed herein, the dielectric film is formed using a ALD deposition method that comprises the steps of:
providing a substrate in a reactor;
introducing into the reactor a containing composition comprising a group 2 metal containing precursor;
chemisorbing the group 2 metal containing precursor onto a substrate;
purging away the unreacted group 2 metal containing precursor using a purge gas;
providing an oxygen source to the group 2 metal containg precursor onto the heated substrate to react with the sorbed at least one group 2 metal containing precursor; and
optionally purging away any unreacted oxygen source.

The above steps define one cycle for the method described herein; and the cycle can be repeated until the desired thickness of a film is obtained. In this or other embodiments, it is understood that the steps of the methods described herein may be performed in a variety of orders, may be performed sequentially or concurrently (e.g. during at least a portion of another step), and any combination thereof. The respective step of supplying the precursors and oxygen source may be performed by varying the duration of the time for supplying them to change the stoichiometric composition of the resulting dielectric film, although always using oxygen in less than a stoichiometric amount relative to the available silicon.

For multi-component films, other precursors such as silicon-containing precursors, nitrogen-containing precursors, reducing agents, or other reagents can be alternately introduced into the reactor chamber.

In a further embodiment of the method described herein, the dielectric film is deposited using a thermal CVD process. In this embodiment, the method comprises:
placing one or more substrates into a reactor which is heated to a temperature ranging from ambient temperature to about 700°C and maintained at a pressure of 1 Torr (130 Pa) or less;
introducing a composition comprising the group 2 metal containing precursor; and
providing an oxygen source into the reactor to at least partially react with the group 2 metal containing precursor and deposit a group 2 metal film onto the one or more substrates. In certain embodiments of the CVD method, the reactor is maintained at a pressure ranging from 100 mTorr to 600 mTorr (13 to 80 Pa) during the introducing step.

The above steps define one cycle for the method described herein; and the cycle can be repeated until the desired thickness of a film is obtained. In this or other embodiments, it is understood that the steps of the methods described herein may be performed in a variety of orders, may be performed sequentially or concurrently (e.g. during at least a portion of another step), and any combination thereof. The respective step of supplying the precursors and oxygen source may be performed by varying the duration of the time for supplying them to change the stoichiometric composition of the resulting film.

For multi-component films, other precursors such as silicon-containing precursors, nitrogen-containing precursors, oxygen sources, reducing agents, and/or other reagents can be alternately introduced into the reactor chamber.

Described herein is a method of depositing a metal containing film by ALD or CVD comprising the use of compositions comprising metal imidazolate precursors of the present invention described above. In one particular embodiment, there is provided a method of depositing a metal containing film by delivering a composition comprising the group 2 imidazolate (adduct) precursor and a compatible solvent to the reaction chamber by DLI delivery then reacting it with an oxygen source selected from the group consisting of water, alcohol, oxygen, ozone, nitrous oxide, nitrogen dioxide, hydrogen peroxide or combinations thereof to grow a metal containing film selected from the group consisting of barium oxide, strontium oxide, magnesium oxide, calcium oxide or radium oxide and mixtures thereof, using a reactor pressure between 0.001-1000 Torr (0.13 Pa to 130 kPa) and a temperature from ranging from 0-1000°C. Depending upon the identity of the group 2 metal, this method results in a deposition of barium oxide or strontium oxide of about 1 Angstrom (Å) or greater per cycle.

Also described herein is a method for depositing a film by ALD or CVD which includes reacting a Ba and Sr imidazolate structure described herein with alternating pulses of titanium precursors selected from the group consisting of titanium alkoxide, titanium alkoxide/diketonate, titanium cyclopentadienyl, titanium amide, titanium imidazolate and mixtures thereof in an ALD or pulsed CVD mode to grow BST films.

In another embodiment, there is described a method of reacting a Sr imidazolate precursor of the present invention with alternating pulses of reacting a Sr imidazolate precursor with alternating pulses of titanium precursors selected from the group consisting of titanium alkoxide, titanium alkoxide/diketonate, titanium cyclopentadienyl, titanium amide, titanium imidazolate and mixtures thereof in an ALD or pulsed CVD mode to grow STO films.

A further embodiment is a method of reacting a Ba imidazolate precursor with alternating pulses of titanium precursors selected from the group consisting of titanium alkoxide, titanium alkoxide/diketonate, titanium alkoxy/ketoester, titanium cyclopentadienyl, titanium amide, titanium imidazolate and mixtures thereof in an ALD or pulsed CVD mode to grow BTO films.

A still further embodiment is a method of reacting a barium imidazolate precursor with a strontium compound selected from the group consisting of strontium ketoiminate, strontium diketonate and mixtures thereof and a titanium compound selected from the group consisting of titanium alkoxide, titanium alkoxide/diketonate, titanium alkoxy/ketoester, titanium cyclopentadienyl, titanium amide and mixtures thereof, in an ALD, CVD or pulsed CVD to grow films of BST.

Yet another embodiment is a method of reacting an imidazolate precursor of with a halide-containing gas selected from the group consisting of HCl, HF, SiCl₄, HBr and mixtures thereof to grow MX₂ where X = halide and M is selected from the group consisting of Ba, Sr, Mg, Ca , Ra and mixtures thereof, in an ALD, CVD or pulsed CVD mode.

Also described herein is a method of synthesizing a precursor described herein by direct metallization of an imidazole with a metal reagent selected from the group consisting of n-butyl lithium, n-hexyl lithium, sec-butyl lithium, tert-butyl lithium, lithium diisopropylamide, potassium hydride, sodium hydride, sodium metal, potassium metal, sodium t-butoxide, potassium t-butoxide, potassium hexamethyldisilazane, sodium hexamethyldisilazane and then reacting the resulting product with a reactant selected from the group consisting of: alkaline earth metal iodide, alkaline earth metal acetate, alkaline earth metal carboxylate, alkaline earth metal carbonate, alkaline earth metal formate, alkaline earth metal bromide, alkaline earth metal trifluoroacetate, alkaline earth metal hexafluoroacetylacetone, alkaline earth metal trifluoroacetylacetonate, alkaline earth metal acetylacetonate, alkaline earth metal diimine, alkaline earth metal ketoimine, alkaline earth metal amidinate, alkaline earth metal guanidinate and mixtures thereof in the presence or absence of the donor coordinating ligand. In the latter case, the donor ligand may be added to the imidazolate complex after its isolation.

A method is described of directly synthesizing an imidazolate structure by reacting a polylalkylated imidazole using a reagent selected from the group consisting of: an alkaline earth metal amide, alkaline earth metal phenoxide, alkaline earth metal hydroxide, alkaline earth metal alkyl, alkaline earth metal aryl and mixtures thereof in the presence or absence of the donor coordinating ligand. In the latter case, the donor ligand may be added to the imidazolate complex after its isolation.

In an alternate embodiment, a method is described of synthesizing an imidazolate structure by reaction of an imidazole with an alkaline earth metal in the presence of ammonia in the presence or absence of the donor coordinating ligand. In the latter case, the donor ligand may be added to the imidazolate complex after its isolation.

Further described is a method of synthesizing an imidazolate structure by reacting an imidazole with an alkaline earth metal in the presence of an amine with ammonia in the presence or absence of the donor coordinating ligand. In the latter case, the donor ligand may be added to the imidazolate complex after its isolation.

A method is described to grow dielectic films selected from the group consisting of: STO and BST using the mixture of metal imidazolates of the present invention to form microelectronic devices selected from the group consisting of dynamic random access memory (DRAM) memory cells and pyrometric devices.

Also a method is described of manufacturing microelectronic devices selected from the group consisting of: non-volatile ferroelectric microelectronic memory devices, display phosphors for electroluminescent displays, high Tc superconducting devices using the imidazolate structures of the present invention.

A method is described of growing a metal oxide or nitride film by ALD or CVD comprising; providing a barium or strontium imidazolate structure in conjunction with titanium sources dissolved in a solvent selected from the group consisting of: an ether, aminoether, amide, ester, aromatic or hydrocarbon solvent and delivering the resulting composition by a DLI system to provide a vapor stream of the resulting composition to grow the metal oxide or nitride film by ALD or CVD.

### EXAMPLES

### Example 1: Strontium bis(2,4,5-tri-tert-butylimidazolate)(tetrahydrofuran)

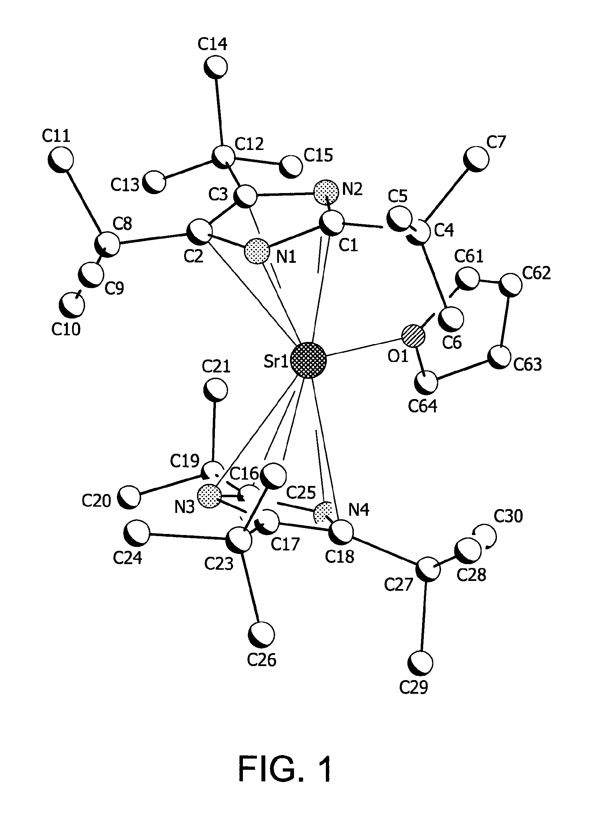

2.79g (0.0025 moles) of di-strontium tetra(2,4,5-tri-tert-butylimidazolate) were stirred in 50 milliliters (ml) of dry hexane under a nitrogen atmosphere. An amount 0.36g (0.005 moles) of tetrahydrofuran was then added over 5 minutes causing the strontium complex to slowly dissolve. The resulting solution was stirred overnight and then the hexane removed by vacuum. The yield was 2.8g. The structure of the final product was determined by X-ray crystallography, shown in Figure 1, was found to be of the type of Formula 2. ¹H NMR: (500 MHz, D8 toluene): δ = 1.34(m, 4H), δ =1.41 (s, 18H), δ = 1.57 (s, 36H), δ = 3.96(m, 4H).

### Example 2: Strontium bis(2,4,5-tri-tert-butylimidazolate)(3-methyltetrahydrofuran)

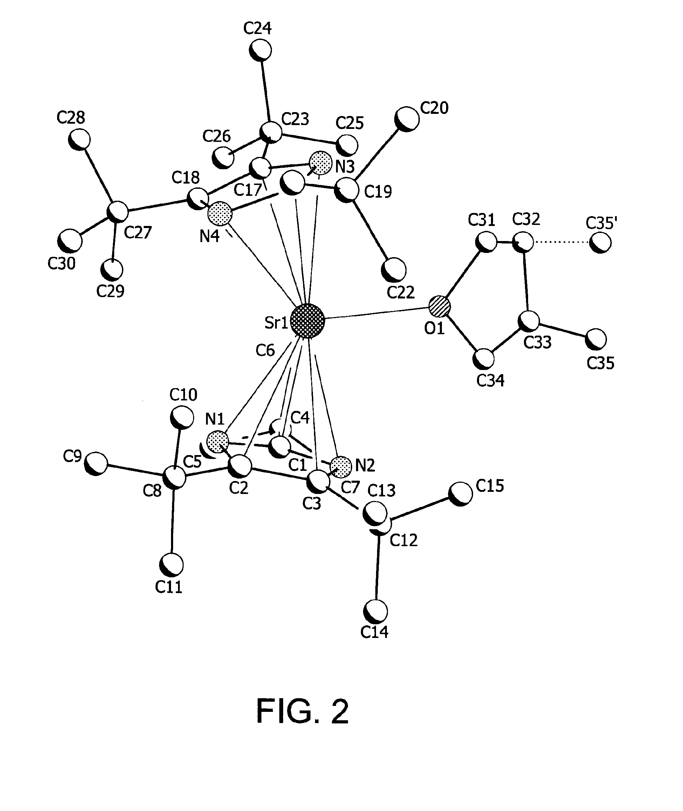

2.79g (0.0025 mol) of di-strontium tetra(2,4,5-tri-tert-butylimidazolate) were stirred in 50ml of dry hexanes under a nitrogen atmosphere. 0.50mL (0.005 mol) of 3-methylTHF were then added and the mixture stirred overnight. The hexane was then removed by vacuum to yield a white solid. The structure of the final product was deterimined by X-ray crystallography, shown in Figure 2, was found to be of the type of Formula 2. Yield: 2.74g, 85%. ¹H NMR: (500 MHz, D8 toluene): δ = 0.72 (d, 3H), δ =1.43 (s, 18H), δ = 1.53(m, 1 H), δ = 1.58 (s,36H), δ = 1.87 (m, 2H), δ = 3.25 (t, 1 H), δ = 4.0035 (m, 2H), δ = 4.3456 (t, 1 H).

### Example 3: Strontium bis(2,4,5-tri-tert-butylimidazolate)(2,5-dihydrofuran)

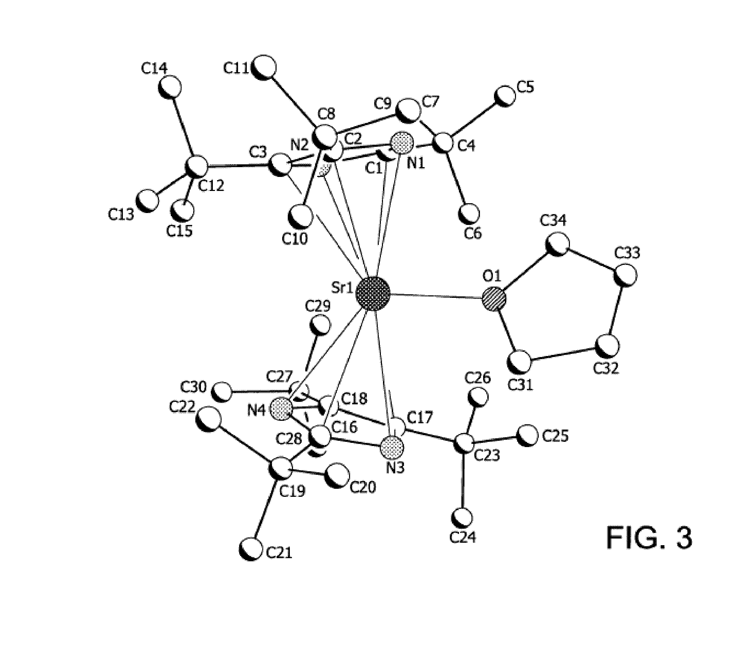

2.79g (0.0025 mol) of di-strontium tetra(2,4,5-tri-tert-butylimidazolate) were stirred in 50ml of dry hexanes under a nitrogen atmosphere. 0.35g (0.005 mol) of 2,5-dihydrofuran were then added and the mixture stirred overnight. The hexane was then removed by vacuum to yield a white solid. The structure of the final product was deterimined by X-ray crystallography, shown in Figure 3, was found to be of the type of Formula 2. ¹H NMR: (500 MHz, D8 toluene): δ = 1.43(s, 18H), δ =1.56(s, 36H), δ = 4.47 (s, 4H), δ = 5.24(s, 2H). Yield = 2.51 g, 80%. TGA: residual mass of 8.09%.

### Example 4: Strontium bis(2,4,5-tri-tert-butylimidazolate)(1,2-dimethoxypropane)

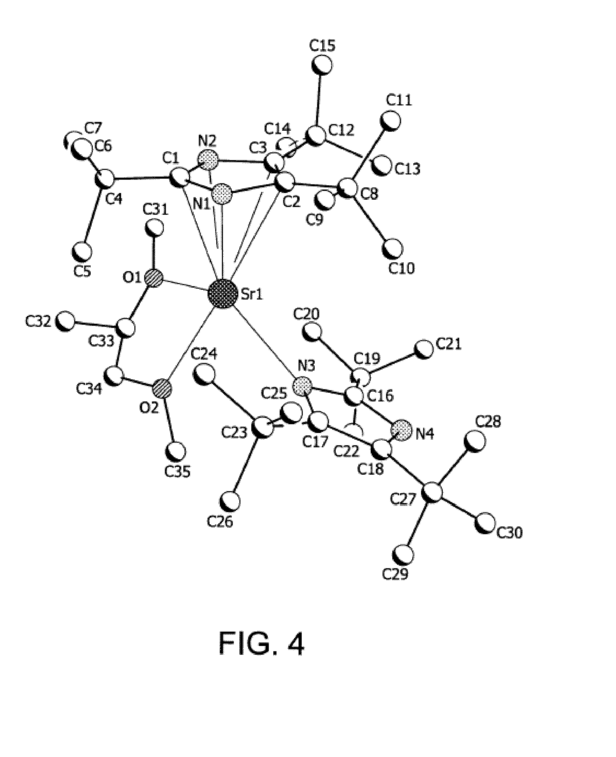

2.79g (0.0025 moles) of di-strontium tetra(2,4,5-tri-tert-butylimidazolate) were stirred in 50ml of dry hexane under a nitrogen atmosphere. 0.52g (0.005 moles) of dimethoxypropane was then added over 5 minutes causing the strontium complex to slowly dissolve. After an additional 20 minutes of stirring, the mixture became cloudy and within an additional 10 minutes a white precipitate was formed. The mixture was then stirred overnight. Hexane was then removed by vacuum to yield a white solid. The yield was 2.83g. ¹H NMR: (500 MHz, D8 toluene): δ = 0.47(d, 3H), δ =1.47(s, 18H), δ = 1.62 (s, 36H), δ = 2.25(m, 1 H), δ = 2.4(m, 1 H), δ = 2.64(m, 1 H), δ = 2.86(s, 3H), δ = 3.02(s, 3H). The structure of the final product was determined by X-ray crystallography, shown in Figure 4, was found to be of the type of Formula 3.

### Example 5: Strontium bis(2,4,5-tri-tert-butylimidazolate)(1,1-dimethoxyethane)

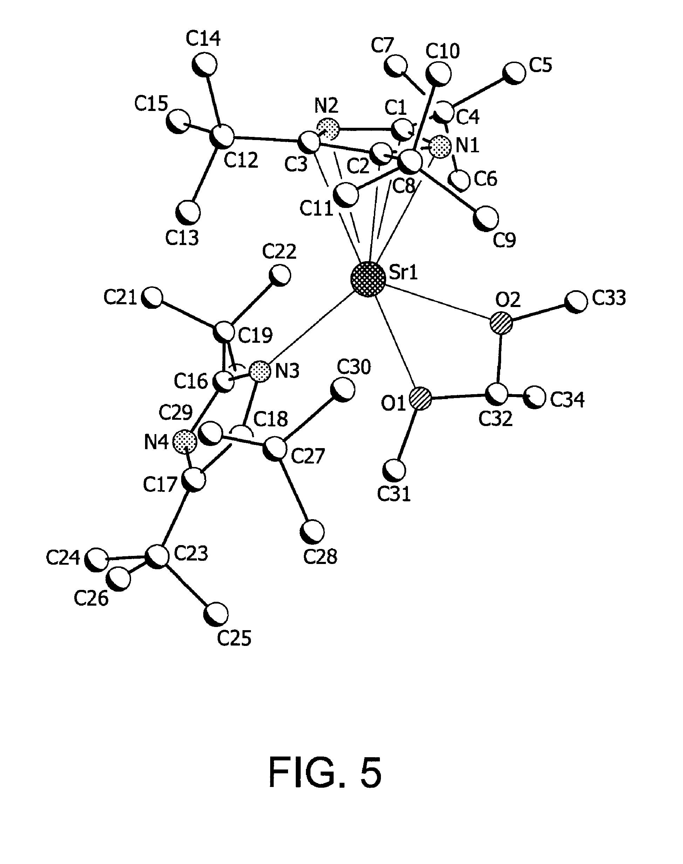

2.79g (0.0025mol) of di-strontium tetra(2,4,5-tri-tert-butylimidazolate) were stirred in 30ml of dry hexanes under a nitrogen atmosphere. 0.53mL (0.005mol) of 1,1-dimethoxyethane were then added and the mixture stirred overnight. The hexane was then removed by vacuum to yield a white solid. Yield = 3.05g, 94%. ¹H NMR: (500 MHz, D8 toluene): δ = 0.61 (d, 3H), δ =1.48(s, 18H), δ = 1.58 (s, 36H), δ = 2.73(s, 6H), δ = 3.58(q, 1 H). The structure of the final product was determined by X-ray crystallography, shown in Figure 5, was found to be of the type of Formula 3.

### Example 6: Strontium bis(2,4,5-tri-tert-butylimidazolate)(tetramethylethylenediamine)

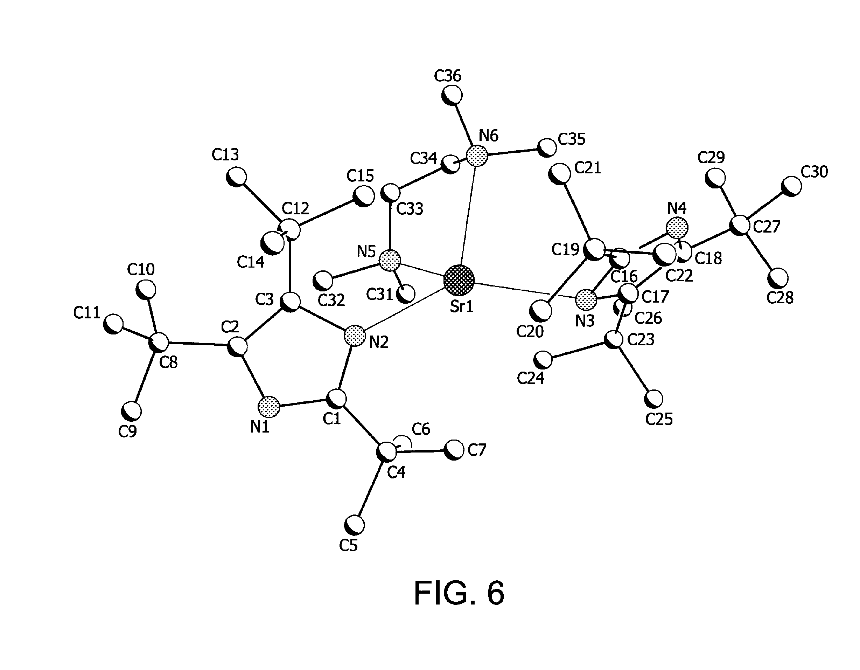

2.79g (0.0025 moles) of di-strontium tetra(2,4,5-tri-tert-butylimidazolate) were stirred in 50ml of dry hexane under a nitrogen atmosphere. 0.58g (0.005 moles) of tetramethylethylenediamine were then added over 5 minutes causing the strontium complex to slowly dissolve. After an additional 20 minutes of stirring, the mixture became cloudy and within an additional 10 minutes a white precipitate was formed. The mixture was then stirred overnight. Hexane was then removed by vacuum to yield a white solid. Yield = 2.8g. ¹H NMR : (500 MHz, D8 toluene): δ = 1.50(s, 18H), δ =1.59(s, 36H), δ = 1.68 (t, 4H), δ = 1.79(s, 12H). The structure of the final product was determined by X-ray crystallography, shown in Figure 6, was found to be of the type of Formula 4.

### Example 7: Attempted Synthesis of Strontium bis(2,4,5-tri-tert-butylimidazolate)(di-n-butylether) (comparative)

2.79g (0.0025 moles) of di-strontium tetra(2,4,5-tri-tert-butylimidazolate) were stirred in 50ml of dry hexane under a nitrogen atmosphere. 0.65g (0.005mol) of di-n-butylether were then added and the mixture stirred overnight. Vacuum was applied to remove the hexane to yield a white solid. NMR of the white solid showed it to be di-strontium tetra(2,4,5-tri-tert-butylimidazolate) indicating that the di-n-butylether was also removed by vacuum and did not form a complex with the strontium imidazolate.

### Example 8: Preparing a 0.37M solution of strontium bis(2,4,5-tri-tert-butylimidazolate)(2,5-dihydrofuran) in cyclooctane

0.29g (0.46 mmoles) of strontium bis(2,4,5-tri-tert-butylimidazolate)(2,5-dihydrofuran) were dissolved in 0.91 g of cyclooctane at room temperature under an atmosphere of dry nitrogen to give a final volume of solution of 1.25 ml weighing 1.2g.

Final molarity of strontium bis(2,4,5-tri-tert-butylimidazolate)(2,5-dihydrofuran) was calculated as 0.00046/0.00125 = 0.37M.

Final wt% of strontium bis(2,4,5-tri-tert-butylimidazolate)(2,5-dihydrofuran) was calculated as 0.29/1.2 = 24 wt%.

### Example 9: Preparing a 0.64M solution of strontium bis(2,4,5-tri-tert-butylimidazolate)(2,5-dihydrofuran) in mesitylene

0.33g (0.53 mmoles) of strontium bis(2,4,5-tri-tert-butylimidazolate)(2,5-dihydrofuran) were dissolved in 0.53g of mesitylene at room temperature under an atmosphere of dry nitrogen to give a final volume of solution of 0.81 ml weighing 0.86g.

Final molarity of strontium bis(2,4,5-tri-tert-butylimidazolate)(2,5-dihydrofuran) was calculated as 0.00053/0.00081 = 0.65M.

Final wt% of strontium bis(2,4,5-tri-tert-butylimidazolate)(2,5-dihydrofuran) was calculated as 0.33/0.86 = 38 wt%.

### Example 10: Direct Liquid Injection of 0.3M strontium bis(2,4,5-tri-tert-butylimidazolate)(tetrahydrofuran) in mesitylene

A 0.3M solution of strontium bis(2,4,5-tri-tert-butylimidazolate)(tetrahydrohydrofuran) in mesitylene was supplied to a model 2830HT DLI system (MSP Corp, USA) at 0.5g/minute, using 500sccm of argon flow through the vaporizer set at 200°C and the resulting vapor stream fed into an ALD reaction chamber set at 1 Torr (130 Pa) pressure. Repeating cycles of 30 second liquid flow controller (LFC) precursor pulses followed by 90 second argon purge were run. Over a 200 minute period, the LFC flow rate per cycle held steady at 0.5g/min thereby illustrating that no clogging of the evaporator and consequent restriction of precursor flow was occurring. This in turn underscores the clean evaporation of the precursor solution. The vapor mixture comprised of mesitylene and strontium bis(2,4,5-tri-tert-butylimidazolate)(tetrahydrohydrofuran) was sampled over the same 200 minute period by a Quadrupole Mass Spectrometer (QMS). The ion current intensities of the molecular fragments 77 and 79 mu, representative of mesitylene present in the composition, were then plotted as a function of time. The QMS readings showed the responses of the 77 and 79 mass unit (mu) fragments to be effectively superimposed as they consistently cycled 1 X 10⁻¹⁰ (liquid flow OFF) and 1X 10⁻⁷ (liquid flow ON). In addition, the QMS pressure was observed to consistently cycles between 3.5 X 10⁻⁶Torr (4.7 x 10⁻⁴ Pa) (liquid flow OFF) and 5.5 X 10⁻⁶Torr (7.3 x 10⁻⁴ Pa) (liquid flow ON), in unison with the mass spectrometer ion current cycles. Together, these results illustrate that the QMS pressure and the flux of mesitylene consistently cycle with the LFC precursor pulses. These results also further illustrated that no clogging of the evaporator and consequent restriction of precursor flow occurred and that the precursor solution cleanly evaporated.

## Claims

1. A composition comprising:
A group 2 metal imidazolate complex comprising: an imidazolate comprising: at least one selected from the group consisting of: 2,4,5-tri-tert-butylimidazolate; 2-tert-butyl-4,5-di-(1,1-dimethylpropyl) imidazolate; 2-(1,1-dimethylbutyl)-4,5-di-tert-butylimidazolate; 2-(1,1-dimethylbutyl)-4,5-di-(1,1-dimethylpropyl)imidazolate; 2-tert-butyl-4,5-di-(1,1-dimethylbutyl)imidazolate; 2,4,5-tri-(1,1-dimethylbutyl)imidazolate; 2,4,5-tri-(1,1-dimethylpropyl)imidazolate; 2-(1,1-dimethylpropyl)-4,5-di-(1,1-dimethylbutyl)imidazolate;and 2-(1,1-dimethylpropyl)-4,5-di-tert-butylimidazolate; a group 2 metal selected from barium, strontium, magnesium, radium, and calcium; and a ligand which coordinates to the group 2 metal imidazolate complex wherein the ligand is at least one selected from the group consisting of a nitrogen-containing monodentate C₄ to C₁₂ cyclic molecule, an oxygen-containing monodentate C₄ to C₁₂ cyclic molecule, a nitrogen-containing C₄ to C₁₂ bidentate ligand, an oxygen-containing C₄ to C₁₂ bidentate ligand, and a C₄ to C₁₂ bidentate ligand comprising nitrogen and oxygen; and
a hydrocarbon solvent having a boiling point of 100°C or greater.

2. The composition of claim 1 where the concentration of Group 2 metal imidazolate complex is in the range of 0.1 to 1 M.

3. The composition of claim 2 where the concentration of Group 2 metal imidazolate complex is in the range of 0.1 to 0.5 M.

4. The composition of any preceding claim where the composition comprises two different group 2 metal imidazolate complexes.

5. The composition of any preceding claim where the hydrocarbon solvent comprises cyclooctane and/or mesitylene.

6. The composition of any preceding claim wherein the composition is used for DLI delivery for the ALD or CVD deposition of group 2 containing thin films.

7. The composition of claim 6 wherein the composition is used in conjunction with a volatile titanium source for the deposition of STO and BST thin films by ALD or CVD.

8. The composition of any preceding claim wherein the ligand comprises one selected from the group consisting of a nitrogen-containing monodentate C₄ to C₁₂ cyclic molecule and an oxygen-containing monodentate C₄ to C₁₂ cyclic molecule.

9. The composition of claim 8 wherein the ligand is one selected from the group consisting of tetrahydrofuran, 3-methyltetrahydrofuran, 2,5-dihydrofuran, 2,3-dihydrofuran, pyridine, N-methylimidazole, and pyrrole.

10. The composition of claim 9 wherein the group 2 metal imidazolate complex is at least one selected from calcium bis(2,4,5-tri-tert-butylimidazolate)(tetrahydrofuran), strontium bis(2,4,5-tri-tert-butylimidazolate)(tetrahydrofuran), barium bis(2,4,5-tri-tert-butylimidazolate)(tetrahydrofuran), calcium bis(2,4,5-tri-tert-butylimidazolate)(3-methyl tetrahydrofuran), strontium bis(2,4,5-tri-tert-butylimidazolate)(3-methyltetrahydrofuran), barium bis(2,4,5-tri-tert-butylimidazolate)(3-methyltetrahydrofuran), calcium bis(2,4,5-tri-tert-butylimidazolate)(2,5-dihydrofuran), strontium bis(2,4,5-tri-tert-butylimidazolate)(2,5-dihydrofuran), barium bis(2,4,5-tri-tert-butylimidazolate)(2,5-dihydrofuran), calcium bis(2,4,5-tri-tert-butylimidazolate)(2,3-dihydrofuran), strontium bis(2,4,5-tri-tert-butylimidazolate)(2,3-dihydrofuran), barium bis(2,4,5-tri-tert-butylimidazolate)(2,3-dihydrofuran), calcium bis(2-tert-butyl-4,5-di-(1,1-dimethylpropyl)imidazolate)(tetrahydrofuran), strontium bis(2-tert-butyl-4,5-di-(1,1-dimethylpropyl)imidazolate)(tetrahydrofuran), barium bis(2-tert-butyl-4,5-di-(1,1-dimethylpropyl)imidazolate)(tetrahydrofuran), calcium bis(2-tert-butyl-4,5-di-(1,1-dimethylpropyl)imidazolate)(3-methyltetrahydrofuran), strontium bis(2-tert-butyl-4,5-di-(1,1-dimethylpropyl)imidazolate)(3-methyl tetrahydrofuran), barium bis(2-tert-butyl-4,5-di-(1,1-dimethylpropyl)imidazolate)(3-methyltetrahydrofuran), calcium bis(2-tert-butyl-4,5-di-(1,1-dimethylpropyl)imidazolate)(2,5-dihydrofuran), strontium bis(2-tert-butyl-4,5-di-(1,1-dimethylpropyl)imidazolate)(2,5-dihydrofuran), barium bis(2-tert-butyl-4,5-di-(1,1-dimethylpropyl)imidazolate)(2,5-dihydrofuran), calcium bis(2-tert-butyl-4,5-di-(1,1-dimethylpropyl)imidazolate)(2,3-dihydrofuran), strontium bis(2-tert-butyl-4,5-di-(1,1-dimethylpropyl)imidazolate)(2,3-dihydrofuran), barium bis(2-tert-butyl-4,5-di-(1,1-dimethylpropyl)imidazolate)(2,3-dihydrofuran), calcium bis(2-tert-butyl-4,5-di-(1,1-dimethylbutyl)imidazolate)(tetrahydrofuran), strontium bis(2-tert-butyl-4,5-di-(1,1-dimethylbutyl)imidazolate)(tetrahydrofuran), barium bis(2-tert-butyl-4,5-di-(1,1-dimethylbutyl)imidazolate)(tetrahydrofuran), calcium bis(2-tert-butyl-4,5-di-(1,1-dimethylbutyl)imidazolate)(3-methyltetrahydrofuran), strontium bis(2-tert-butyl-4,5-di-(1,1-dimethylbutyl)imidazolate)(3-methyltetrahydrofuran), barium bis(2-tert-butyl-4,5-di-(1,1-dimethylbutyl)imidazolate)(3-methyltetrahydrofuran), calcium bis(2-tert-butyl-4,5-di-(1,1-dimethylbutyl)imidazolate)(2,5-dihydrofuran), strontium bis(2-tert-butyl-4,5-di-(1,1-dimethylbutyl)imidazolate)(2,5-dihydrofuran), barium bis(2-tert-butyl-4,5-di-(1,1-dimethylbutyl)imidazolate)(2,5-dihydrofuran), calcium bis(2-tert-butyl-4,5-di-(1,1-dimethylbutyl)imidazolate)(2,3-dihydrofuran), strontium bis(2-tert-butyl-4,5-di-(1,1-dimethylbutyl)imidazolate)(2,3-dihydrofuran), barium bis(2-tert-butyl-4,5-di-(1,1-dimethylbutyl)imidazolate)(2,3-dihydrofuran), calcium bis(2,4,5-tri-(1,1-dimethylbutyl)imidazolate)(tetrahydrofuran), strontium bis(2,4,5-tri-(1,1-dimethylbutyl)imidazolate)(tetrahydrofuran), barium bis(2,4,5-tri-(1,1-dimethylbutyl)imidazolate)(tetrahydrofuran), calcium bis(2,4,5-tri-(1,1-dimethylbutyl)imidazolate)(3-methyltetrahydrofuran), strontium bis(2,4,5-tri-(1,1-dimethylbutyl)imidazolate)(3-methyltetrahydrofuran), barium bis(2,4,5-tri-(1,1-dimethylbutyl)imidazolate)(3-methyl tetrahydrofuran), calcium bis(2,4,5-tri-(1,1-dimethylbutyl)imidazolate)(2,5-hydrofuran), strontium bis(2,4,5-tri-(1,1-dimethylbutyl)imidazolate)(2,5-hydrofuran), barium bis(2,4,5-tri-(1,1-dimethylbutyl)imidazolate (2,5-dihydrofuran), calcium bis(2,4,5-tri-(1,1-dimethylbutyl)imidazolate)(2,3-dihydrofuran), strontium bis(2,4,5-tri-(1,1-dimethylbutyl)limidazolate)(2,3-dihydrofuran), barium bis(2,4,5-tri-(1,1-dimethylbutyl) imidazolate) (2,3-dihydrofuran), calcium bis(2-(1,1-dimethylbutyl)-4,5-di-(1,1-dimethylpropyl)imidazolate) (tetrahydrofuran), strontium bis(2-(1,1-dimethylbutyl)-4,5-di-(1,1-dimethylpropyl)imidazolate)(tetrahydrofuran), barium bis(2-(1,1-dimethylbutyl) -4,5-di-(1,1-dimethylpropyl)imidazolate)(tetrahydrofuran), calcium bis(2-(1,1-dimethylbutyl)-4,5-di-(1,1-dimethylpropyl))imidazolate)(3-methyltetrahydrofuran), strontium bis(2-(1,1-dimethylbutyl)-4,5-di-(1,1-dimethylpropyl))imidazolate)(3-methyltetrahydrofuran), barium bis(2-(1,1-dimethylbutyl)-4,5-di-(1,1-dimethylpropyl)imidazolate (3-methyltetrahydrofuran), calcium bis(2-(1,1-dimethylbutyl)-4,5-di-(1,1-dimethylpropyl)imidazolate)(2,5-dihydrofuran), strontium bis(2-(1,1-dimethylbutyl)-4,5-di-(1,1-dimethylpropyl)imidazolate)(2,5-dihydrofuran), barium bis(2-(1,1-dimethylbutyl)-4,5-di-(1,1-dimethylpropyl)imidazolate)(2,5-dihydrofuran), calcium bis(2-(1,1-dimethylbutyl) -4,5-di-(1,1-dimethylpropyl)imidazolate)(2,3-dihydrofuran), strontium bis(2-(1,1-dimethylbutyl)-4,5-di-(1,1-dimethylpropyl)imidazolate)(2,3-dihydrofuran), barium bis(2-(1,1-dimethylbutyl)-4,5-di-(1,1-dimethylpropyl)imidazolate)(2,3-dihydrofuran), calcium bis(2,4,5-tri-(1,1-dimethylbutyl)imidazolate)) (tetrahydrofuran), strontium bis(2,4,5-tri-(1,1-dimethylbutyl)imidazolate) (tetrahydrofuran), barium bis(2,4,5-tri-(1,1-dimethylbutyl)imidazolate) (tetrahydrofuran), calcium bis(2,4,5-tri-(1,1-dimethylbutyl)imidazolate)(3-methyltetrahydrofuran), strontium bis(2,4,5-tri-(1,1-dimethylbutyl)imidazolate)(3-methyltetrahydrofuran), barium bis(2,4,5-tri-(1,1-dimethylbutyl)imidazolate)(3-methyl tetrahydrofuran), calcium bis(2,4,5-tri-(1,1-dimethylbutyl)imidazolate)(2,5-dihydrofuran), strontium bis(2,4,5-tri-(1,1-dimethylbutyl)imidazolate)(2,5-dihydrofuran), barium bis(2,4,5-tri-(1,1-dimethylbutyl)imidazolate) (2,5-dihydrofuran), calcium bis(2,4,5-tri-(1,1-dimethylbutyl)imidazolate)(2,3-dihydrofuran), strontium bis(2,4,5-tri-(1,1-dimethylbutyl)imidazolate)(2,3-dihydrofuran), barium bis(2,4,5-tri-(1,1-dimethylbutyl)imidazolate)(2,3-dihydrofuran), calcium bis(2-(1,1-dimethylpropyl)-4,5-di-(1,1-dimethylbutyl)imidazolate)(tetrahydrofuran), strontium bis(2-(1,1-dimethylpropyl)-4,5-di-(1,1-dimethylbutyl)imidazolate)(tetrahydrofuran), barium bis(2-(1,1-dimethylpropyl)-4,5-di-(1,1-dimethylbutyl)imidazolate)(tetrahydrofuran), calcium bis(2-(1,1-dimethylpropyl)-4,5-di-(1,1-dimethylbutyl)imidazolate)(3-methyltetrahydrofuran), strontium bis(2-(1,1-dimethylpropyl)-4,5-di-(1,1-dimethylbutyl)imidazolate)(3-methyltetrahydrofuran), barium bis(2-(1,1-dimethylpropyl)-4,5-di-(1,1-dimethylbutyl)imidazolate)(3-methyltetrahydrofuran), calcium bis(2-(1,1-dimethylpropyl)-4,5-di-(1,1-dimethylbutyl)imidazolate)(2,5-dihydrofuran), strontium bis(2-(1,1-dimethylpropyl)-4,5-di-(1,1-dimethylbutyl)imidazolate)(2,5-dihydrofuran), barium bis(2-(1,1-dimethylpropyl)-4,5-di-(1,1-dimethylbutyl)imidazolate)(2,5-dihydrofuran), calcium bis(2-(1,1-dimethylpropyl)-4,5-di-(1,1-dimethylbutyl)imidazolate)(2,3-dihydrofuran), strontium bis(2-(1,1-dimethylpropyl)-4,5-di-(1,1-dimethylbutyl)imidazolate)(2,3-dihydrofuran), barium bis(2-(1,1-dimethylpropyl)-4,5-di-(1,1-dimethylbutyl)imidazolate)(2,3-dihydrofuran), calcium bis(2,4,5-tri-(1,1-dimethylpropyl)imidazolate)(tetrahydrofuran), strontium bis(2,4,5-tri-(1,1-dimethylpropyl)imidazolate)(tetrahydrofuran), barium bis(2,4,5-tri-(1,1-dimethylpropyl)imidazolate)(tetrahydrofuran), calcium bis(2,4,5-(1,1-dimethylpropyl)imidazolate)(3-methyltetrahydrofuran), strontium bis(2,4,5-tri-(1,1-dimethylpropyl)imidazolate)(3-methyltetrahydrofuran), barium bis(2,4,5-tri-(1,1-dimethylpropyl)imidazolate)(3-methyltetrahydrofuran), calcium bis(2,4,5-tri-(1,1-dimethylpropyl) imidazolate)(2,5-dihydrofuran), strontium bis(2,4,5-tri-(1,1-dimethylpropyl)imidazolate)(2,5-dihydrofuran), barium bis(2,4,5-tri-(1,1-dimethylpropyl)imidazolate)(2,5-dihydrofuran), calcium bis(2,4,5-tri-(1,1-dimethylpropyl)imidazolate)(2,3-dihydrofuran), strontium bis(2,4,5-tri-(1,1-dimethylpropyl)imidazolate)(2,3-dihydrofuran), barium bis(2,4,5-tri-(1,1-dimethylpropyl)- imidazolate)(2,3-dihydrofuran), calcium bis(2-(1,1-dimethylpropyl)-4,5-di-tert-butylimidazolate)(tetrahydrofuran), strontium bis(2-(1,1-dimethylpropyl)-4,5-di-tert-butylimidazolate)(tetrahydrofuran), barium bis(2-(1,1-dimethylpropyl)-4,5-di-tert-butylimidazolate)(tetrahydrofuran), calcium bis(2-(1,1-dimethylpropyl)-4,5-di-tert-butylimidazolate)(3-methyltetrahydrofuran), strontium bis(2-(1,1-dimethylpropyl)-4,5-di-tert-butylimidazolate)(3-methyltetrahydrofuran), barium bis(2-(1,1-dimethylpropyl)-4,5-di-tert-butylimidazolate)(3-methyltetrahydrofuran), calcium bis(2-(1,1-dimethylpropyl)-4,5-di-tert-butylimidazolate)(2,5-dihydrofuran), strontium bis(2-(1,1-dimethylpropyl)-4,5-di-tert-butylimidazolate)(2,5-dihydrofuran), barium bis(2-(1,1-dimethylpropyl)-4,5-di-tert-butylimidazolate)(2,5-dihydrofuran), calcium bis(2-(1,1-dimethylpropyl)-4,5-di-tert-butylimidazolate)(2,3-dihydrofuran), strontium bis(2-(1,1-dimethylpropyl)-4,5-di-tert-butylimidazolate)(2,3-dihydrofuran), and barium bis(2-(1,1-dimethylpropyl)-4,5-di-tert-butylimidazolate)(2,3-dihydrofuran).

11. A method for forming a group 2 metal oxide film on a substrate wherein the film comprises a thickness, the method comprising:
a. introducing a group 2 metal containing composition comprising:
a group 2 metal imidazolate complex comprising: an imidazolate comprising: at least one selected from the group consisting of: 2,4,5-tri-tert-butylimidazolate; 2-tert-butyl-4,5-di-(1,1-dimethylpropyl) imidazolate; 2-(1,1-dimethylbutyl)-4,5-di-tert-butylimidazolate; 2-(1,1-dimethylbutyl)-4,5-di-(1,1-dimethylpropyl)imidazolate; 2-tert-butyl-4,5-di-(1,1-dimethylbutyl)imidazolate; 2,4,5-tri-(1,1-dimethylbutyl)imidazolate; 2,4,5-tri-(1,1-dimethylpropyl)imidazolate; 2-(1,1-dimethylpropyl)-4,5-di-(1,1-dimethylbutyl)imidazolate; and 2-(1,1-dimethylpropyl)-4,5-di-tert-butylimidazolate; a group 2 metal selected from barium, strontium, magnesium, radium, and calcium; and a ligand which coordinates the group 2 metal to the imidazolate in the complex wherein the ligand is at least one selected from the group consisting of a nitrogen-containing monodentate C₄ to C₁₂ cyclic molecule, an oxygen-containing monodentate C₄ to C₁₂ cyclic molecule, a nitrogen-containing C₄ to C₁₂ bidentate ligand, an oxygen-containing C₄ to C₁₂ bidentate ligand, and a C₄ to C₁₂ bidentate ligand containing both nitrogen and oxygen; and
a hydrocarbon solvent having a boiling point of 100°C or greater;
b. chemisorbing the group 2 metal containing composition onto the substrate;
c. purging away the unreacted group 2 metal containing composition using a purge gas;
d. providing an oxygen source to the group 2 metal containing composition onto the heated substrate to react with the sorbed the group 2 metal containing composition; and
e. optionally purging away any unreacted oxygen source.

12. The method of claim 11 wherein steps a. through d. and optional step e. are repeated until the thickness of film is established.

13. The method of claim 11 or claim 12 wherein the method is an atomic layer deposition process.

## Patentansprüche

1. Zusammensetzung, umfassend:
einen Gruppe 2 Metall-Imidazolatkomplex, umfassend:
ein Imidazolat umfassend: mindestens eines ausgewählt aus der Gruppe, die aus: 2,4,5-Tri-tert-butylimidazolat; 2-tert-Butyl-4,5-di-(1,1-dimethylpropyl)imidazolat; 2-(1,1-Dimethylbutyl)-4,5-di-tert-butylimidazolat; 2-(1,1-Dimethylbutyl)-4,5-di-(1,1-dimethylpropyl)imidazolat; 2-tert-Butyl-4,5-di-(1,1-dimethylbutyl)imidazolat; 2,4,5-Tri-(1,1-dimethylbutyl)imidazolat; 2,4,5-Tri-(1,1-dimethylpropyl)imidazolat; 2-(1,1-Dimethylpropyl)-4,5-di-(1,1-dimethylbutyl)imidazolat; und 2-(1,1-Dimethylpropyl)-4,5-di-tert-butylimidazolat besteht;
ein Gruppe 2 Metall, ausgewählt aus Barium, Strontium, Magnesium, Radium und Calcium;
und einen Liganden, der an den Gruppe 2 Metall-Imidazolatkomplex koordiniert, wobei der Ligand mindestens einer ausgewählt aus der Gruppe ist, die aus einem Stickstoff-haltigen Monodentat C₄ bis C₁₂ cyclischen Molekül, einem Sauerstoff-haltigen Monodentat C₄ bis C₁₂ cyclischen Molekül, einem Stickstoff-haltigen C₄ bis C₁₂ Bidentat-Liganden, einem Sauerstoff-haltigen C₄ bis C₁₂ Bidentat-Liganden und einem C₄ bis C₁₂ Bidentat-Liganden, der Stickstoff und Sauerstoff enthält, besteht; und
ein Kohlenhydratlösungsmittel, das einen Siedepunkt von 100 °C oder höher hat.

2. Zusammensetzung nach Anspruch 1, wobei die Konzentration des Gruppe 2 Metall-Imidazolatkomplexes in dem Bereich von 0,1 bis 1 M ist.

3. Zusammensetzung nach Anspruch 2, wobei die Konzentration des Gruppe 2 Metall-Imidazolatkomplexes in dem Bereich von 0,1 bis 0,5 M ist.

4. Zusammensetzung nach einem der vorhergehenden Ansprüche, wobei die Zusammensetzung zwei verschiedene Gruppe 2 Metall-Imidazolatkomplexe umfasst.

5. Zusammensetzung nach einem der vorhergehenden Ansprüche, wobei das Kohlenwasserstofflösungsmittel Cyclooctan und/oder Mesitylen umfasst.

6. Zusammensetzung nach einem der vorhergehenden Ansprüche, wobei die Zusammensetzung zur Zuführung mittels direkter Flüssigkeitseinspritzung, DLI, für die atomare Gasphasenabscheidung, ALD, oder chemische Gasphasenabscheidung, CVD, von Gruppe 2-haltigen Dünnschichten verwendet wird.

7. Zusammensetzung nach Anspruch 6, wobei die Zusammensetzung in Verbindung mit einer flüchtigen Titanquelle für die Abscheidung von STO-und BST-Dünnschichten mittels ALD oder CVD verwendet wird.

8. Zusammensetzung nach einem der vorhergehenden Ansprüche, wobei der Ligand einen umfasst, der aus der Gruppe ausgewählt ist, die aus einem Stickstoff-haltigen Monodentat C₄ bis C₁₂ cyclischen Molekül und einem Sauerstoff-haltigen Monodentat C₄ bis C₁₂ cyclischen Molekül besteht.

9. Zusammensetzung nach Anspruch 8, wobei der Ligand einer ausgewählt aus der Gruppe ist, die aus Tetrahydrofuran, 3-Methyltetrahydrofuran, 2,5-Dihydrofuran, 2,3-Dihydrofuran, Pyridin, N-Methylimidazol und Pyrrol besteht.

10. Zusammensetzung nach Anspruch 9, wobei der Gruppe 2 Metall-Imidazolatkomplex mindestens einer ist, ausgewählt aus Calcium-bis(2,4,5-tri-tert-butylimidazolat)(tetrahydrofuran), Strontium-bis(2,4,5-tri-tert-butylimidazolat)(tetrahydrofuran), Barium-bis(2,4,5-tri-tert-butylimidazolat)(tetrahydrofuran), Calcium-bis(2,4,5-tri-tert-butylimidazolat)(3-methyltetrahydrofuran), Strontium-bis(2,4,5-tri-tert-butylimidazolat)(3-methyltetrahydrofuran), Barium-bis(2,4,5-tri-tert-butylimidazolat)(3-methyltetrahydrofuran), Calcium-bis(2,4,5-tri-tert-butylimidazolat)(2,5-dihydrofuran), Strontium-bis(2,4,5-tri-tert-butylimidazolat)(2,5-dihydrofuran), Barium-bis(2,4,5-tri-tert-butylimidazolat)(2,5-dihydrofuran), Calcium-bis(2,4,5-tri-tert-butylimidazolat)(2,3-dihydrofuran), Strontium-bis(2,4,5-tri-tert-butylimidazolat)(2,3-dihydrofuran), Barium-bis(2,4,5-tri-tert-butylimidazolat)(2,3-dihydrofuran), Calcium-bis(2-tert-butyl-4,5-di-(1,1-dimethylpropyl)imidazolat)(tetrahydrofuran), Strontium-bis(2-tert-butyl-4,5-di-(1,1-dimethylpropyl)imidazolat)(tetrahydrofuran), Barium-bis(2-tert-butyl-4,5-di-(1,1-dimethylpropyl)imidazolat)(tetrahydrofuran), Calcium-bis(2-tert-butyl-4,5-di-(1,1-dimethylpropyl)imidazolat)(3-methyltetrahydrofuran), Strontium-bis(2-tert-butyl-4,5-di-(1,1-dimethylpropyl)imidazolat)(3-methyltetrahydrofuran), Barium-bis(2-tert-butyl-4,5-di-(1,1-dimethylpropyl)imidazolat)(3-methyltetrahydrofuran), Calcium-bis(2-tert-butyl-4,5-di-(1,1-dimethylpropyl)imidazolat)(2,5-dihydrofuran), Strontium-bis(2-tert-butyl-4,5-di-(1,1-dimethylpropyl)imidazolat)(2,5-dihydrofuran), Barium-bis(2-tert-butyl-4,5-di-(1,1-dimethylpropyl)imidazolat)(2,5-dihydrofuran), Calcium-bis(2-tert-butyl-4,5-di-(1,1-dimethylpropyl)imidazolat)(2,3-dihydrofuran), Strontium-bis(2-tert-butyl-4,5-di-(1,1-dimethylpropyl)imidazolat)(2,3-dihydrofuran), Barium-bis(2-tert-butyl-4,5-di-(1,1-dimethylpropyl)imidazolat)(2,3-dihydrofuran), Calcium-bis(2-tert-butyl-4,5-di-(1,1-dimethylbutyl)imidazolat)(tetrahydrofuran), Strontium-bis(2-tert-butyl-4,5-di-(1,1-dimethylbutyl)imidazolat)(tetrahydrofuran), Barium-bis(2-tert-butyl-4,5-di-(1,1-dimethylbutyl)imidazolat)(tetrahydrofuran), Calcium-bis(2-tert-butyl-4,5-di-(1,1-dimethylbutyl)imidazolat)(3-methyltetrahydrofuran), Strontium-bis(2-tert-butyl-4,5-di-(1,1-dimethylbutyl)imidazolat)(3-methyltetrahydrofuran), Barium-bis(2-tert-butyl-4,5-di-(1,1-dimethylbutyl)imidazolat)(3-methyltetrahydrofuran), Calcium-bis(2-tert-butyl-4,5-di-(1,1-dimethylbutyl)imidazolat)(2,5-dihydrofuran), Strontium-bis(2-tert-butyl-4,5-di-(1,1-dimethylbutyl)imidazolat)(2,5-dihydrofuran), Barium-bis(2-tert-butyl-4,5-di-(1,1-dimethylbutyl)imidazolat)(2,5-dihydrofuran), Calcium-bis(2-tert-butyl-4,5-di-(1,1-dimethylbutyl)imidazolat)(2,3-dihydrofuran), Strontium-bis(2-tert-butyl-4,5-di-(1,1-dimethylbutyl)imidazolat)(2,3-dihydrofuran), Barium-bis(2-tert-butyl-4,5-di-(1,1-dimethylbutyl)imidazolat)(2,3-dihydrofuran), Calcium-bis(2,4,5-tri-(1,1-dimethylbutyl)imidazolat)(tetrahydrofuran), Strontium-bis(2,4,5-tri-(1,1-dimethylbutyl)imidazolat)(tetrahydrofuran), Barium-bis(2,4,5-tri-(1,1-dimethylbutyl)imidazolat)(tetrahydrofuran), Calcium-bis(2,4,5-tri-(1,1-dimethylbutyl)imidazolat)(3-methyltetrahydrofuran), Strontium-bis(2,4,5-tri-(1,1-dimethylbutyl)imidazolat)(3-methyltetrahydrofuran), Barium-bis(2,4,5-tri-(1,1-dimethylbutyl)imidazolat)(3-methyltetrahydrofuran), Calcium-bis(2,4,5-tri-(1,1-dimethylbutyl)imidazolat)(2,5-hydrofuran), Strontium-bis(2,4,5-tri-(1,1-dimethylbutyl)imidazolat)(2,5-hydrofuran), Barium-bis(2,4,5-tri-(1,1-dimethylbutyl)imidazolat)(2,5-dihydrofuran), Calcium-bis(2,4,5-tri-(1,1-dimethylbutyl)imidazolat)(2,3-dihydrofuran), Strontium-bis(2,4,5-tri-(1,1-dimethylbutyl)imidazolat)(2,3-dihydrofuran), Barium-bis(2,4,5-tri-(1,1-dimethylbutyl)imidazolat)(2,3-dihydrofuran), Calcium-bis(2-(1,1-dimethylbutyl)-4,5-di-(1,1-dimethylpropyl)imidazolat)(tetrahydrofuran), Strontium-bis(2-(1,1-dimethylbutyl)-4,5-di-(1,1-dimethylpropyl)imidazolat)(tetrahydrofuran), Barium-bis(2-(1,1-dimethylbutyl)-4,5-di-(1,1-dimethylpropyl)imidazolat)(tetrahydrofuran), Calcium-bis(2-(1,1-dimethylbutyl)-4,5-di-(1,1-dimethylpropyl))imidazolat)(3-methyltetrahydrofuran), Strontium-bis(2-(1,1-dimethylbutyl)-4,5-di-(1,1-dimethylpropyl))imidazolat)(3-methyltetrahydrofuran), Barium-bis(2-(1,1-dimethylbutyl)-4,5-di-(1,1-dimethylpropyl)imidazolat)(3-methyltetrahydrofuran), Calcium-bis(2-(1,1-dimethylbutyl)-4,5-di-(1,1-dimethylpropyl)imidazolat)(2,5-dihydrofuran), Strontium-bis(2-(1,1-dimethylbutyl)-4,5-di-(1,1-dimethylpropyl)imidazolat)(2,5-dihydrofuran), Barium-bis(2-(1,1-dimethylbutyl)-4,5-di-(1,1-dimethylpropyl)imidazolat)(2,5-dihydrofuran), Calcium-bis(2-(1,1-dimethylbutyl)-4,5-di-(1,1-dimethylpropyl)imidazolat)(2,3-dihydrofuran), Strontium-bis(2-(1,1-dimethylbutyl)-4,5-di-(1,1-dimethylpropyl)imidazolat)(2,3-dihydrofuran), Barium-bis(2-(1,1-dimethylbutyl)-4,5-di-(1,1-dimethylpropyl)imidazolat)(2,3-dihydrofuran), Calcium-bis(2,4,5-tri-(1,1-dimethylbutyl)imidazolat) (tetrahydrofuran), Strontium-bis(2,4,5-tri-(1,1-dimethylbutyl)imidazolat) (tetrahydrofuran), Barium-bis(2,4,5-tri-(1,1-dimethylbutyl)imidazolat) (tetrahydrofuran), Calcium-bis(2,4,5-tri-(1,1-dimethylbutyl)imidazolat)(3-methyltetrahydrofuran), Strontium-bis(2,4,5-tri-(1,1-dimethylbutyl)imidazolat)(3-methyltetrahydrofuran), Barium-bis(2,4,5-tri-(1,1-dimethylbutyl)imidazolat)(3-methyltetrahydrofuran), Calcium-bis(2,4,5-tri-(1,1-dimethylbutyl)imidazolat)(2,5-dihydrofuran), Strontium-bis(2,4,5-tri-(1,1-dimethylbutyl)imidazolat)(2,5-dihydrofuran), Barium-bis(2,4,5-tri-(1,1-dimethylbutyl)imidazolat)(2,5-dihydrofuran), Calcium-bis(2,4,5-tri-(1,1-dimethylbutyl)imidazolat)(2,3-dihydrofuran), Strontium-bis(2,4,5-tri-(1,1-dimethylbutyl)imidazolat)(2,3-dihydrofuran), Barium-bis(2,4,5-tri-(1,1-dimethylbutyl)imidazolat)(2,3-dihydrofuran), Calcium-bis(2-(1,1-dimethylpropyl)-4,5-di-(1,1-dimethylbutyl)imidazolat)(tetrahydrofuran), Strontium-bis(2-(1,1-dimethylpropyl)-4,5-di-(1,1-dimethylbutyl)imidazolat)(tetrahydrofuran), Barium-bis(2-(1,1-dimethylpropyl)-4,5-di-(1,1-dimethylbutyl)imidazolat)(tetrahydrofuran), Calcium-bis(2-(1,1-dimethylpropyl)-4,5-di-(1,1-dimethylbutyl)imidazolat)(3-methyltetrahydrofuran), Strontium-bis(2-(1,1-dimethylpropyl)-4,5-di-(1,1-dimethylbutyl)imidazolat)(3-methyltetrahydrofuran), Barium-bis(2-(1,1-dimethylpropyl)-4,5-di-(1,1-dimethylbutyl)imidazolat)(3-methyltetrahydrofuran), Calcium-bis(2-(1,1-dimethylpropyl)-4,5-di-(1,1-dimethylbutyl)imidazolat)(2,5-dihydrofuran), Strontium-bis(2-(1,1-dimethylpropyl)-4,5-di-(1,1-dimethylbutyl)imidazolat)(2,5-dihydrofuran), Barium-bis(2-(1,1-dimethylpropyl)-4,5-di-(1,1-dimethylbutyl)imidazolat)(2,5-dihydrofuran), Calcium-bis(2-(1,1-dimethylpropyl)-4,5-di-(1,1-dimethylbutyl)imidazolat)(2,3-dihydrofuran), Strontium-bis(2-(1,1-dimethylpropyl)-4,5-di-(1,1-dimethylbutyl)imidazolat)(2,3-dihydrofuran), Barium-bis(2-(1,1-dimethylpropyl)-4,5-di-(1,1-dimethylbutyl)imidazolat)(2,3-dihydrofuran), Calcium-bis(2,4,5-tri-(1,1-dimethylpropyl)imidazolat)(tetrahydrofuran), Strontium-bis(2,4,5-tri-(1,1-dimethylpropyl)imidazolat)(tetrahydrofuran), Barium-bis(2,4,5-tri-(1,1-dimethylpropyl)imidazolat)(tetrahydrofuran), Calcium-bis(2,4,5-(1,1-dimethylpropyl)imidazolat)(3-methyltetrahydrofuran), Strontium-bis(2,4,5-tri-(1,1-dimethylpropyl)imidazolat)(3-methyltetrahydrofuran), Barium-bis(2,4,5-tri-(1,1-dimethylpropyl)imidazolat)(3-methyltetrahydrofuran), Calcium-bis(2,4,5-tri-(1,1-dimethylpropyl)imidazolat)(2,5-dihydrofuran), Strontium-bis(2,4,5-tri-(1,1-dimethylpropyl)imidazolat)(2,5-dihydrofuran), Barium-bis(2,4,5-tri-(1,1-dimethylpropyl)imidazolat)(2,5-dihydrofuran), Calcium-bis(2,4,5-tri-(1,1-dimethylpropyl)imidazolat)(2,3-dihydrofuran), Strontium-bis(2,4,5-tri-(1,1-dimethylpropyl)imidazolat)(2,3-dihydrofuran), Barium-bis(2,4,5-tri-(1,1-dimethylpropyl)imidazolat)(2,3-dihydrofuran), Calcium-bis(2-(1,1-dimethylpropyl)-4,5-di-tert-butylimidazolat)(tetrahydrofuran), Strontium-bis(2-(1,1-dimethylpropyl)-4,5-di-tert-butylimidazolat)(tetrahydrofuran), Barium-bis(2-(1,1-dimethylpropyl)-4,5-di-tert-butylimidazolat)(tetrahydrofuran), Calcium-bis(2-(1,1-dimethylpropyl)-4,5-di-tert-butylimidazolat)(3-methyltetrahydrofuran), Strontium-bis(2-(1,1-dimethylpropyl)-4,5-di-tert-butylimidazolat)(3-methyltetrahydrofuran), Barium-bis(2-(1,1-dimethylpropyl)-4,5-di-tert-butylimidazolat)(3-methyltetrahydrofuran), Calcium-bis(2-(1,1-dimethylpropyl)-4,5-di-tert-butylimidazolat)(2,5-dihydrofuran), Strontium-bis(2-(1,1-dimethylpropyl)-4,5-di-tert-butylimidazolat)(2,5-dihydrofuran), Barium-bis(2-(1,1-dimethylpropyl)-4,5-di-tert-butylimidazolat)(2,5-dihydrofuran), Calcium-bis(2-(1,1-dimethylpropyl)-4,5-di-tert-butylimidazolat)(2,3-dihydrofuran), Strontium-bis(2-(1,1-dimethylpropyl)-4,5-di-tert-butylimidazolat)(2,3-dihydrofuran) und Barium-bis(2-(1,1-dimethylpropyl)-4,5-di-tert-butylimidazolat)(2,3-dihydrofuran).

11. Verfahren zur Bildung einer Gruppe 2 Metalloxidschicht auf einem Substrat, wobei die Schicht eine Dicke umfasst und wobei das Verfahren umfasst:
a. Einführen einer Gruppe 2 Metall-haltigen Zusammensetzung, umfassend:
einen Gruppe 2 Metall-Imidazolatkomplex, umfassend:
ein Imidazolat umfassend: mindestens eines ausgewählt aus der Gruppe, die aus: 2,4,5-Tri-tert-butylimidazolat; 2-tert-Butyl-4,5-di-(1,1-dimethylpropyl)imidazolat; 2-(1,1-Dimethylbutyl)-4,5-di-tert-butylimidazolat; 2-(1,1-Dimethylbutyl)-4,5-di-(1,1-dimethylpropyl)imidazolat; 2-tert-Butyl-4,5-di-(1,1-dimethylbutyl)imidazolat; 2,4,5-Tri-(1,1-dimethylbutyl)imidazolat; 2,4,5-Tri-(1,1-dimethylpropyl)imidazolat; 2-(1,1-Dimethylpropyl)-4,5-di-(1,1-dimethylbutyl)imidazolat; und 2-(1,1-Dimethylpropyl)-4,5-di-tert-butylimidazolat besteht;
ein Gruppe 2 Metall, ausgewählt aus Barium, Strontium, Magnesium, Radium und Calcium; und
einen Liganden, der in dem Komplex das Gruppe 2 Metall an das Imidazolat koordiniert, wobei der Ligand mindestens einer ausgewählt aus der Gruppe ist, die aus einem Stickstoff-haltigen Monodentat C₄ bis C₁₂ cyclischen Molekül, einem Sauerstoff-haltigen Monodentat C₄ bis C₁₂ cyclischen Molekül, einem Stickstoff-haltigen C₄ bis C₁₂ Bidentat-Liganden, einem Sauerstoff-haltigen C₄ bis C₁₂ Bidentat-Liganden und einem C₄ bis C₁₂ Bidentat-Liganden, der Stickstoff und Sauerstoff enthält, besteht; und ein Kohlenhydratlösungsmittel, das einen Siedepunkt von 100 °C oder höher hat;
b. Chemisorbieren der Gruppe 2 Metall-haltigen Zusammensetzung auf dem Substrat;
c. Wegspülen der nicht-reagierten Gruppe 2 Metall-haltigen Zusammensetzung, wobei ein Spülgas verwendet wird;
d. Bereitstellen einer Sauerstoffquelle zu der Gruppe 2 Metallhaltigen Zusammensetzung auf dem erhitzen Substrat, um mit der sorbierten Gruppe 2 Metall-haltigen Zusammensetzung zu reagieren; und
e. optional Wegspülen von jeglicher nicht-reagierter Sauerstoffquelle.

12. Verfahren nach Anspruch 11, wobei die Schritte a. bis d. und optional Schritt e. wiederholt werden, bis die Dicke der Schicht aufgebaut ist.

13. Verfahren nach Anspruch 11 oder 12, wobei das Verfahren ein Atomlagenabscheidungsverfahren ist.

## Revendications

1. Composition comprenant :
un complexe d'imidazolate de métal du groupe 2 comprenant : un imidazolate comprenant : au moins l'un choisi dans le groupe constitué des : imidazolate de 2,4,5-tri-tert-butyle ; imidazolate de 2-tert-butyl-4,5-di-(1,1-diméthylpropyle) ; imidazolate de 2-(1,1-diméthylbutyl)-4,5-di-tert-butyle ; imidazolate de 2-(1,1-diméthylbutyl)-4,5-di-(1,1-diméthylpropyle) ; imidazolate de 2-tert-butyl-4,5-di-(1,1-diméthylbutyle) ; imidazolate de 2,4,5-tri-(1,1-diméthylbutyle) ; imidazolate de 2,4,5-tri-(1,1-diméthylpropyle) ; imidazolate de 2-(1,1-diméthylpropyl)-4,5-di-(1,1-diméthylbutyle) ;et imidazolate de 2-(1,1-diméthylpropyl)-4,5-di-tert-butyle ; un métal du groupe 2 choisi parmi le baryum, le strontium, le magnésium, le radium, et le calcium ; et un ligand qui est coordonné au complexe d'imidazolate de métal du groupe 2, le ligand étant au moins l'un choisi dans le groupe constitué d'une molécule cyclique en C₄ à C₁₂ monodentée contenant de l'azote, une molécule cyclique en C₄ à C₁₂ monodentée contenant de l'oxygène, un ligand bidenté en C₄ à C₁₂ contenant de l'azote, un ligand bidenté en C₄ à C₁₂ contenant de l'oxygène, et un ligand bidenté en C₄ à C₁₂ comprenant de l'azote et de l'oxygène ; et
un solvant hydrocarbure ayant un point d'ébullition de 100 °C ou plus.

2. Composition de la revendication 1 dans laquelle la concentration de complexe d'imidazolate de métal du groupe 2 est dans la plage de 0,1 à 1 M.

3. Composition de la revendication 2 dans laquelle la concentration de complexe d'imidazolate de métal du groupe 2 est dans la plage de 0,1 à 0,5 M.

4. Composition de l'une quelconque des revendications précédentes dans laquelle la composition comprend deux complexes d'imidazolate de métal du groupe 2 différents.

5. Composition de l'une quelconque des revendications précédentes dans laquelle le solvant hydrocarbure comprend le cyclooctane et/ou le mésitylène.

6. Composition de l'une quelconque des revendications précédentes dans laquelle la composition est utilisée pour la délivrance de DLI pour le dépôt ALD ou CVD de couches minces contenant des métaux du groupe 2.

7. Composition de la revendication 6, la composition étant utilisée conjointement avec une source de titane volatile pour le dépôt de couches minces STO et BST par ALD ou CVD.

8. Composition de l'une quelconque des revendications précédentes dans laquelle le ligand comprend l'un choisi dans le groupe constitué d'une molécule cyclique en C₄ à C₁₂ monodentée contenant de l'azote et une molécule cyclique en C₄ à C₁₂ monodentée contenant de l'oxygène.

9. Composition de la revendication 8 dans laquelle le ligand est l'un choisi dans le groupe constitué du tétrahydrofurane, du 3-méthyltétrahydrofurane, du 2,5-dihydrofurane, du 2,3-dihydrofurane, de la pyridine, du N-méthylimidazole, et du pyrrole.

10. Composition de la revendication 9 dans laquelle le complexe d'imidazolate de métal du groupe 2 est au moins l'un choisi parmi les bis(2,4,5-tri-tert-butylimidazolate)(tétrahydrofurane) de calcium, bis(2,4,5-tri-tert-butylimidazolate)(tétrahydrofurane) de strontium, bis(2,4,5-tri-tert-butylimidazolate)(tétrahydrofurane) de baryum, bis(2,4,5-tri-tert-butylimidazolate)(3-méthyltétrahydrofurane) de calcium, bis(2,4,5-tri-tert-butylimidazolate)(3-méthyltétrahydrofurane) de strontium, bis(2,4,5-tri-tert-butylimidazolate)(3-méthyltétrahydrofurane) de baryum, bis(2,4,5-tri-tert-butylimidazolate)(2,5-dihydrofurane) de calcium, bis(2,4,5-tri-tert-butylimidazolate)(2,5-dihydrofurane) de strontium, bis(2,4,5-tri-tert-butylimidazolate)(2,5-dihydrofurane) de baryum, bis(2,4,5-tri-tert-butylimidazolate)(2,3-dihydrofurane) de calcium, bis(2,4,5-tri-tert-butylimidazolate)(2,3-dihydrofurane) de strontium, bis(2,4,5-tri-tert-butylimidazolate)(2,3-dihydrofurane) de baryum, bis(2-tert-butyl-4,5-di-(1,1-diméthylpropyl)imidazolate)(tétrahydrofurane) de calcium, bis(2-tert-butyl-4,5-di-(1,1-diméthylpropyl)imidazolate)(tétrahydrofurane) de strontium, bis(2-tert-butyl-4,5-di-(1,1-diméthylpropyl)imidazolate)(tétrahydrofurane) de baryum, bis(2-tert-butyl-4,5-di-(1,1-diméthylpropyl)imidazolate)(3-méthyltétrahydrofurane) de calcium, bis(2-tert-butyl-4,5-di-(1,1-diméthylpropyl)imidazolate)(3-méthyl-tétrahydrofurane) de strontium, bis(2-tert-butyl-4,5-di-(1,1-diméthylpropyl)imidazolate)(3-méthyltétrahydrofurane) de baryum, bis(2-tert-butyl-4,5-di-(1,1-diméthylpropyl)imidazolate)(2,5-dihydrofurane) de calcium, bis(2-tert-butyl-4,5-di-(1,1-diméthylpropyl)imidazolate)(2,5-dihydrofurane) de strontium, bis(2-tert-butyl-4,5-di-(1,1-diméthylpropyl)imidazolate)(2,5-dihydrofurane) de baryum, bis(2-tert-butyl-4,5-di-(1,1-diméthylpropyl)imidazolate)(2,3-dihydrofurane) de calcium, bis(2-tert-butyl-4,5-di-(1,1-diméthylpropyl)imidazolate)(2,3-dihydrofurane) de strontium, bis(2-tert-butyl-4,5-di-(1,1-diméthylpropyl)imidazolate)(2,3-dihydrofurane) de baryum, bis(2-tert-butyl-4,5-di-(1,1-diméthylbutyl)imidazolate)(tétrahydrofurane) de calcium, bis(2-tert-butyl-4,5-di-(1,1-diméthylbutyl)imidazolate)(tétrahydrofurane) de strontium, bis(2-tert-butyl-4,5-di-(1,1-diméthylbutyl)imidazolate)(tétrahydrofurane) de baryum, bis(2-tert-butyl-4,5-di-(1,1-diméthylbutyl)imidazolate)(3-méthyltétrahydrofurane) de calcium, bis(2-tert-butyl-4,5-di-(1,1-diméthylbutyl)imidazolate)(3-méthyltétrahydrofurane) de strontium, bis(2-tert-butyl-4,5-di-(1,1-diméthylbutyl)imidazolate)(3-méthyltétrahydrofurane) de baryum, bis(2-tert-butyl-4,5-di-(1,1-diméthylbutyl)imidazolate)(2,5-dihydrofurane) de calcium, bis(2-tert-butyl-4,5-di-(1,1-diméthylbutyl)imidazolate)(2,5-dihydrofurane) de strontium, bis(2-tert-butyl-4,5-di-(1,1-diméthylbutyl)imidazolate)(2,5-dihydrofurane) de baryum, bis(2-tert-butyl-4,5-di-(1,1-diméthylbutyl)imidazolate)(2,3-dihydrofurane) de calcium, bis(2-tert-butyl-4,5-di-(1,1-diméthylbutyl)imidazolate)(2,3-dihydrofurane) de strontium, bis(2-tert-butyl-4,5-di-(1,1-diméthylbutyl)imidazolate)(2,3-dihydrofurane) de baryum, bis(2,4,5-tri-(1,1-diméthylbutyl)imidazolate)(tétrahydrofurane) de calcium, bis(2,4,5-tri-(1,1-diméthylbutyl)imidazolate)(tétrahydrofurane) de strontium, bis(2,4,5-tri-(1,1-diméthylbutyl)imidazolate)(tétrahydrofurane) de baryum, bis(2,4,5-tri-(1,1-diméthylbutyl)imidazolate)(3-méthyltétrahydrofurane) de calcium, bis(2,4,5-tri-(1,1-diméthylbutyl)imidazolate)(3-méthyltétrahydrofurane) de strontium, bis(2,4,5-tri-(1,1-diméthylbutyl)imidazolate)(3-méthyltétrahydrofurane) de baryum, bis(2,4,5-tri-(1,1-diméthylbutyl)imidazolate)(2,5-hydrofurane) de calcium, bis(2,4,5-tri-(1,1-diméthylbutyl)imidazolate)(2,5-hydrofurane) de strontium, bis(2,4,5-tri-(1,1-diméthylbutyl)imidazolate)(2,5-dihydrofurane) de baryum, bis(2,4,5-tri-(1,1-diméthylbutyl)imidazolate)(2,3-dihydrofurane) de calcium, bis(2,4,5-tri-(1,1-diméthylbutyl)limidazolate)(2,3-dihydrofurane) de strontium, bis(2,4,5-tri-(1,1-diméthylbutyl)imidazolate)(2,3-dihydrofurane) de baryum, bis(2-(1,1-diméthylbutyl)-4,5-di-(1,1-diméthylpropyl)imidazolate)(tétrahydrofurane) de calcium, bis(2-(1,1-diméthylbutyl)-4,5-di-(1,1-diméthylpropyl)imidazolate)(tétrahydrofurane) de strontium, bis(2-(1,1-diméthylbutyl)-4,5-di-(1,1-diméthylpropyl)imidazolate)(tétrahydrofurane) de baryum, bis(2-(1,1-diméthylbutyl)-4,5-di-(1,1-diméthylpropyl))imidazolate)(3-méthyltétrahydrofurane) de calcium, bis(2-(1,1-diméthylbutyl)-4,5-di-(1,1-diméthylpropyl))imidazolate)(3-méthyltétrahydrofurane) de strontium, bis(2-(1,1-diméthylbutyl)-4,5-di-(1,1-diméthylpropyl)imidazolate(3-méthyltétrahydrofurane) de baryum, bis(2-(1,1-diméthylbutyl)-4,5-di-(1,1-diméthylpropyl)imidazolate)(2,5-dihydrofurane) de calcium, bis(2-(1,1-diméthylbutyl)-4,5-di-(1,1-diméthylpropyl)imidazolate)(2,5-dihydrofurane) de strontium, bis(2-(1,1-diméthylbutyl)-4,5-di-(1,1-diméthylpropyl)imidazolate)(2,5-dihydrofurane) de baryum, bis(2-(1,1-diméthylbutyl)-4,5-di-(1,1-diméthylpropyl)imidazolate)(2,3-dihydrofurane) de calcium, bis(2-(1,1-diméthylbutyl)-4,5-di-(1,1-diméthylpropyl)imidazolate)(2,3-dihydrofurane) de strontium, bis(2-(1,1-diméthylbutyl)-4,5-di-(1,1-diméthylpropyl)imidazolate)(2,3-dihydrofurane) de baryum, bis(2,4,5-tri-(1,1-diméthylbutyl)imidazolate))(tétrahydrofurane) de calcium, bis(2,4,5-tri-(1,1-diméthylbutyl)imidazolate)(tétrahydrofurane) de strontium, bis(2,4,5-tri-(1,1-diméthylbutyl)imidazolate)(tétrahydrofurane) de baryum, bis(2,4,5-tri-(1,1-diméthylbutyl)imidazolate)(3-méthyltétrahydrofurane) de calcium, bis(2,4,5-tri-(1,1-diméthylbutyl)imidazolate)(3-méthyltétrahydrofurane) de strontium, bis(2,4,5-tri-(1,1-diméthylbutyl)imidazolate)(3-méthyltétrahydrofurane) de baryum, bis(2,4,5-tri-(1,1-diméthylbutyl)imidazolate)(2,5-dihydrofurane) de calcium, bis(2,4,5-tri-(1,1-diméthylbutyl)imidazolate)(2,5-dihydrofurane) de strontium, bis(2,4,5-tri-(1,1-diméthylbutyl)imidazolate)(2,5-dihydrofurane) de baryum, bis(2,4,5-tri-(1,1-diméthylbutyl)imidazolate)(2,3-dihydrofurane) de calcium, bis(2,4,5-tri-(1,1-diméthylbutyl)imidazolate)(2,3-dihydrofurane) de strontium, bis(2,4,5-tri-(1,1-diméthylbutyl)imidazolate)(2,3-dihydrofurane) de baryum, bis(2-(1,1-diméthylpropyl)-4,5-di-(1,1-diméthylbutyl)imidazolate)(tétrahydrofurane) de calcium, bis(2-(1,1-diméthylpropyl)-4,5-di-(1,1-diméthylbutyl)imidazolate)(tétrahydrofurane) de strontium, bis(2-(1,1-diméthylpropyl)-4,5-di-(1,1-diméthylbutyl)imidazolate)(tétrahydrofurane) de baryum, bis(2-(1,1-diméthylpropyl)-4,5-di-(1,1-diméthylbutyl)imidazolate)(3-méthyltétrahydrofurane) de calcium, bis(2-(1,1-diméthylpropyl)-4,5-di-(1,1-diméthylbutyl)imidazolate)(3-méthyltétrahydrofurane) de strontium, bis(2-(1,1-diméthylpropyl)-4,5-di-(1,1-diméthylbutyl)imidazolate)(3-méthyltétrahydrofurane) de baryum, bis(2-(1,1-diméthylpropyl)-4,5-di-(1,1-diméthylbutyl)imidazolate)(2,5-dihydrofurane) de calcium, bis(2-(1,1-diméthylpropyl)-4,5-di-(1,1-diméthylbutyl)imidazolate)(2,5-dihydrofurane) de strontium, bis(2-(1,1-diméthylpropyl)-4,5-di-(1,1-diméthylbutyl)imidazolate)(2,5-dihydrofurane) de baryum, bis(2-(1,1-diméthylpropyl)-4,5-di-(1,1-diméthylbutyl)imidazolate)(2,3-dihydrofurane) de calcium, bis(2-(1,1-diméthylpropyl)-4,5-di-(1,1-diméthylbutyl)imidazolate)(2,3-dihydrofurane) de strontium, bis(2-(1,1-diméthylpropyl)-4,5-di-(1,1-diméthylbutyl)imidazolate)(2,3-dihydrofurane) de baryum, bis(2,4,5-tri-(1,1-diméthylpropyl)imidazolate)(tétrahydrofurane) de calcium, bis(2,4,5-tri-(1,1-diméthylpropyl)imidazolate)(tétrahydrofurane) de strontium, bis(2,4,5-tri-(1,1-diméthylpropyl)imidazolate)(tétrahydrofurane) de baryum, bis(2,4,5-(1,1-diméthylpropyl)imidazolate)(3-méthyltétrahydrofurane) de calcium, bis(2,4,5-tri-(1,1-diméthylpropyl)imidazolate)(3-méthyltétrahydrofurane) de strontium, bis(2,4,5-tri-(1,1-diméthylpropyl)imidazolate)(3-méthyltétrahydrofurane) de baryum, bis(2,4,5-tri-(1,1-diméthylpropyl)imidazolate)(2,5-dihydrofurane) de calcium, bis(2,4,5-tri-(1,1-diméthylpropyl)imidazolate)(2,5-dihydrofurane) de strontium, bis(2,4,5-tri-(1,1-diméthylpropyl)imidazolate)(2,5-dihydrofurane) de baryum, bis(2,4,5-tri-(1,1-diméthylpropyl)imidazolate)(2,3-dihydrofurane) de calcium, bis(2,4,5-tri-(1,1-diméthylpropyl)imidazolate)(2,3-dihydrofurane) de strontium, bis(2,4,5-tri-(1,1-diméthylpropyl)-imidazolate)(2,3-dihydrofurane) de baryum, bis(2-(1,1-diméthylpropyl)-4,5-di-tert-butylimidazolate)(tétrahydrofurane) de calcium, bis(2-(1,1-diméthylpropyl)-4,5-di-tert-butylimidazolate)(tétrahydrofurane) de strontium, bis(2-(1,1-diméthylpropyl)-4,5-di-tert-butylimidazolate)(tétrahydrofurane) de baryum, bis(2-(1,1-diméthylpropyl)-4,5-di-tert-butylimidazolate)(3-méthyltétrahydrofurane) de calcium, bis(2-(1,1-diméthylpropyl)-4,5-di-tert-butylimidazolate)(3-méthyltétrahydrofurane) de strontium, bis(2-(1,1-diméthylpropyl)-4,5-di-tert-butylimidazolate)(3-méthyltétrahydrofurane) de baryum, bis(2-(1,1-diméthylpropyl)-4,5-di-tert-butylimidazolate)(2,5-dihydrofurane) de calcium, bis(2-(1,1-diméthylpropyl)-4,5-di-tert-butylimidazolate)(2,5-dihydrofurane) de strontium, bis(2-(1,1-diméthylpropyl)-4,5-di-tert-butylimidazolate)(2,5-dihydrofurane) de baryum, bis(2-(1,1-diméthylpropyl)-4,5-di-tert-butylimidazolate)(2,3-dihydrofurane) de calcium, bis(2-(1,1-diméthylpropyl)-4,5-di-tert-butylimidazolate)(2,3-dihydrofurane) de strontium et bis(2-(1,1-diméthylpropyl)-4,5-di-tert-butylimidazolate)(2,3-dihydrofurane) de baryum.

11. Procédé de formation d'un film d'oxyde de métal du groupe 2 sur un substrat dans lequel le film comprend une épaisseur, le procédé comprenant :
a. l'introduction d'une composition contenant un métal du groupe 2 comprenant :
un complexe d'imidazolate de métal du groupe 2 comprenant : an imidazolate comprenant : au moins l'un choisi dans le groupe constitué des : imidazolate de 2,4,5-tri-tert-butyle ; imidazolate de 2-tert-butyl-4,5-di-(1,1-diméthylpropyle) ; imidazolate de 2-(1,1-diméthylbutyl)-4,5-di-tert-butyle ; imidazolate de 2-(1,1-diméthylbutyl)-4,5-di-(1,1-diméthylpropyle) ; imidazolate de 2-tert-butyl-4,5-di-(1,1-diméthylbutyle) ; imidazolate de 2,4,5-tri-(1,1-diméthylbutyle) ; imidazolate de 2,4,5-tri-(1,1-diméthylpropyle) ; imidazolate de 2-(1,1-diméthylpropyl)-4,5-di-(1,1-diméthylbutyle) ; et imidazolate de 2-(1,1-diméthylpropyl)-4,5-di-tert-butyle ; un métal du groupe 2 choisi parmi le baryum, le strontium, le magnésium, le radium, et le calcium ; et un ligand qui coordonne le métal du groupe 2 avec l'imidazolate dans le complexe où le ligand est au moins l'un choisi dans le groupe constitué d'une molécule cyclique en C₄ à C₁₂ monodentée contenant de l'azote, une molécule cyclique en C₄ à C₁₂ monodentée contenant de l'oxygène, un ligand bidenté en C₄ à C₁₂ contenant de l'azote, un ligand bidenté en C₄ à C₁₂ contenant de l'oxygène, et un ligand bidenté en C₄ à C₁₂ contenant à la fois de l'azote et de l'oxygène ; et
a. un solvant hydrocarbure ayant un point d'ébullition de 100 °C ou plus ;
b. la chimisorption de la composition contenant un métal du groupe 2 sur le substrat ;
c. la purge de la composition contenant un métal du groupe 2 n'ayant pas réagi au moyen d'un gaz de purge ;
d. la fourniture d'une source d'oxygène à la composition contenant un métal du groupe 2 sur le substrat chauffé pour réagir avec la composition contenant un métal du groupe 2 sorbée ; et
e. facultativement la purge de la source d'oxygène n'ayant éventuellement pas réagi.

12. Procédé de la revendication 11 dans lequel les étapes a. à d. et l'étape facultative e. sont répétées jusqu'à ce que l'épaisseur de film soit atteinte.

13. Procédé de la revendication 11 ou la revendication 12, le procédé étant un procédé de dépôt de couche atomique.
